(19) Europäisches Patentamt
European Patent Office
Office européen des brevets

(11) **EP 2 172 416 A1**

(12) **EUROPEAN PATENT APPLICATION**
published in accordance with Art. 153(4) EPC

(43) Veröffentlichungstag:
**07.04.2010  Patentblatt 2010/14**

(51) Int Cl.:
***B82B 1/00*** *(2006.01)*   ***B82B 3/00*** *(2006.01)*

(21) Anmeldenummer: **08779181.0**

(22) Anmeldetag: **28.05.2008**

(86) Internationale Anmeldenummer:
**PCT/RU2008/000331**

(87) Internationale Veröffentlichungsnummer:
**WO 2009/002215 (31.12.2008 Gazette 2009/01)**

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**
Benannte Erstreckungsstaaten:
**AL BA MK RS**

(30) Priorität: **22.06.2007  RU 2007123444**

(71) Anmelder:
• **Khartov, Stanislav Viktorovich**
  **Krasnoyarsky krai 662978 (RU)**

• **Nevolin, Vladimir Kirillovich**
  **Moscow 124482 (RU)**

(72) Erfinder: **SIMUNIN, Mihail Maksimovich**
  **Moscow 125617 (RU)**

(74) Vertreter: **Jeck, Anton**
  **Jeck - Fleck - Herrmann**
  **Patentanwälte**
  **Klingengasse 2/1**
  **71665 Vaihingen/Enz (DE)**

(54) **NANO-ELEKTROMECHANISCHE STRUKTUR UND HERSTELLUNGSVERFAHREN DAFÜR**

(57)    Die Erfindung betrifft eine nanoelektromechanische Struktur für verschiedene Anwendungen in der Sensortechnik und der Mikrotechnik sowie ein Verfahren zu ihrer Herstellung. Ist dabei vorgesehen, dass sie folgende Elemente einschließt: mindestens ein steuerbares, stromleitfähiges Element, wenigstens eine Eingangselektrode, die im elektrischen Kontakt mit dem steuerbaren Element steht und wenigstens eine Ausgangselektrode, die vom steuerbaren Element getrennt und mit dem steuerbaren Element elektrostatisch gekoppelt ist, wobei entweder mindestens ein Teil der Ausgangselektrode aus einem Material ausgebildet ist, welches irreversible physikalische oder chemische Änderungen bei physikalischer oder chemischer und durch das steuerbare Element vermittelter Einwirkung bewirkt oder mindestens ein Teil des steuerbaren Elements aus einem Material ausgebildet ist, welches irreversible physikalische oder chemische Änderungen bei physikalischer oder chemischer und durch die Ausgangselektrode vermittelter Einwirkung bewirkt, dann können die Integrationsstufe und die Betriebsfrequenz, die Stabilität, die Empfindlichkeit und die Selektivität erhöht werden.

EP 2 172 416 A1

**Beschreibung**

Die Erfindung betrifft eine nanoelektromechanische Struktur nach dem Oberbegriff des Anspruchs 1 und Verfahren zu ihrer Herstellung.

Die Erfindung betrifft mikro- und nanoelektromechanische Einrichtungen, deren Anwendung Mikroelektronik, Mikrosystem- und Sensortechnik umfasst. Die Erfindung bezieht sich auch auf ein Verfahren zur Herstellung von diesen Einrichtungen.

Das Anwendungspotential der Nanostrukturen als Funktionselemente ist schwer einzuschätzen. Großes Interesse erweckt z.B. die Anwendung von Nanostrukturen in mechanischen Resonatoren für Signalbearbeitungssysteme. Solche Resonatoren müssen die zur Integralschaltung der äußeren Filter auf der Basis von relativ großen Quarzresonatoren ersetzen. Es gibt auch MEMS-Resonatoren (Resonatoren auf Basis der mikroelektromechanischen Systeme). Diese Technik beruht auf der Nutzung der mechanischen Bewegung eines aufgehängten Siliziumbalkens. Jedoch betreffen die typischen Abmessungen des Siliziumbalkens den Mikrometerbereich. Das bedingt eine Eigenschwingungszahl von einigen MHz. Bei höheren Frequenzen sinkt der Gütefaktor bei den Resonatoren dieses Typs. Außerdem erweisen sich sowohl der Dynamikbereich als auch die Einstellungsmöglichkeit der Resonanzfrequenz des Siliziumbalkens als sehr begrenzt. Das Problem der Umsetzung der mechanischen Bewegung des Balkens in ein elektrisches Ausgangssignal wird auch verschärft (W002080360). Die Anwendung von Nanostrukturen als Grundlage für mechanische Resonatoren wird es ermöglichen, die oben genannten Mängel zu überwinden und rauscharme Hochfrequenzresonatoren mit hohem Gütefaktor herzustellen.

Die mechanischen Oszillatoren können auch als Bauelementebasis für digitale Datenverarbeitungssysteme betrachtet werden. Während der Entwicklung der Halbleiterelektronik setzte sich die Miniaturisierung der elektronischen Einrichtungen ununterbrochen fort. Jede neue Gerätegeneration zeichnete sich durch noch kleinere Abmessungen und eine höhere Auslösungsgeschwindigkeit aus. Die Fläche der zur Ausführung von spezifischen Funktionen erforderlichen Siliziumchips wurde alle 1,5 Jahre halbiert. Die Geräteabmessungen nahmen gleichmäßig im Zeitraum von den Fünfziger Jahren bis Ende der Achtziger Jahre ab (angefangen mit 10 cm in Vakuumgeräten und unter 1 $\mu$m in Integralschaltungen). In den Neunziger Jahren bahnte sich ein Bruch in dieser Entwicklung bzw. eine Sättigung dieser Abhängigkeit an. Das hing einerseits mit den grundsätzlichen physikalischen Einschränkungen zusammen, welche eine weitere Verkleinerung verhinderten. Andererseits lag das an einer Exponentialsteigerung der Kosten für die erforderlichen Produktionskapazitäten.

Die Kostensteigerung hängt damit zusammen, dass die Rahmen des technischen Vermögens der konventionellen Fotolithografie längst überschritten waren. Die weitere Verkleinerung der Planarabmessungen der Bauelemente bedarf einer Verkürzung der Belichtungswellenlänge sowie der Anwendung von unterschiedlichen zusätzlichen (ergänzenden) technischen Lösungen. Dies alles führt zum Kompliziertwerden und zur Verteuerung der Fotolithografieausrüstung und zur Herabsetzung der Endausbeute.

Die Alternativen für die Lithografie sind eine elektronische und eine Ionenstrahllithografie. Ihr Hauptmangel ist eine zu niedrige Leistungsfähigkeit. Dies führt im Endeffekt ebenfalls zur beachtlichen Kostensteigerung.

Abgesehen von diesem Lithografieproblem besteht auch ein Problem der Betriebsfähigkeitsstörung der Siliziumgeräte bei nachfolgender Miniaturisierung. Das ist durch folgende physikalische Einschränkungen bedingt:

- Beimischungsdichtefluktuation
  Der Halbleiterelektronik liegt ein Dotierungsvorgang, d.h. die Zugabe von Zusatzstoffen, zugrunde. Jedoch erfolgt die Verteilung dieser Zusatzstoffe nach dem Zufallsprinzip und ist daher Fluktuationen ausgesetzt. Die quadratische Mittelfluktuation $\Delta$ N der Zusatzstoffmenge N = n $\cdot$ V in einem Musterumfang V beträgt:

$$\Delta N \approx N^{1/2} = (n \cdot V)^{1/2}$$

  Um die Geräte mit kontrollierbaren Eigenschaften zu entwickeln, darf die relative Fluktuation der Beimischungsdichte im vorgegebenen Umfang 1 % nicht überschreiten, d.h. $N^{1/2}/N \leq 0,01$, folglich N = n $\cdot$ V $\geq 10^4$. Bei einer mittleren Beimischungsdichte n $\approx 10^{18}$ cm$^{-3}$ wird der Umfang der Einrichtung auf V > $10^{-14}$ cm$^3$ beschränkt. Das bedeutet, dass die linearen Abmessungen der Einrichtung 0,2 $\mu$m nicht unterschreiten dürfen.

- Beimischungsdiffusion auf der Oberfläche
  Der Beimischungsdiffusionskoeffizient auf der Oberfläche wird viel höher als im Umfang. Dieser Umstand begrenzt wesentlich die waagerechten Abmessungen der Einrichtungen durch den Wert von > 0,1 $\mu$m.

- Änderung des Elektronentransportverhaltens

Wenn die Einrichtungsabmessungen kleiner sind als manche typische Längen, die die Kinetik der Transportphänomene festlegen, ändert sich der eigentliche Charakter des Elektronentransports. Zum Beispiel, wenn die Einrichtungsgröße kleiner als die freie Weglänge der Träger 1 ist, so wird der Transport ballistisch. Das erhöht einerseits die Schnellwirkung, weil die Aufenthaltszeit des Elektrons in der Einrichtung und damit die Zeitdauer von beliebigen physikalischen Abläufen minimal ist (gegenüber dem Transport durch Diffusion). Jedoch lässt sich dabei andererseits die Empfindlichkeit gegenüber der Ausführung der Einrichtung erkennen. Das betrifft insbesondere das Streuungsverhalten an den Grenzen. (Folglich werden die Anforderungen an das Fertigungsverfahren der entsprechenden Einrichtungen verschärft).

Ein weiterer wesentlicher Faktor hängt mit den Quanteninterferenzeffekten zusammen. Er zeigt sich in einer solchen Situation, wenn der Transport innerhalb der Einrichtung phasen-kohärent ist. Das ist der Fall, wenn die Abmessung der Einrichtung kleiner ist als die Diffusionslänge in Bezug auf die Phasenausfallverläufe. Die Phasenkohärenz trägt zu einer grundsätzlich neuen Physik bei. Insbesondere nimmt die Empfindlichkeit der Einrichtungskennwerte gegenüber der konkreten Realisierung der Raumverteilung der Beimischungen zu. Es entstehen komplizierte Abhängigkeiten zwischen dem Widerstand und dem elektrischen und magnetischen Feld (so genannte mesoskopische Effekte). Darüber hinaus verschärft sich das Problem der elektrischen Ladungsableitungen infolge des Tunneleffekts. Das verringert insbesondere die temporäre Stabilität der erzeugten Speicherelemente. Die genannten Umstände hängen im Wesentlichen mit den dimensionalen Effekten zusammen (im ersten Fall mit den klassischen und im zweiten Fall mit den Quanteneffekten). Diese Umstände verursachen grundsätzliche Einschränkungen bei der Herstellung von Kleineinrichtungen.

- Erhitzung der Integralschaltungen
Unter Strom wird die Erhitzung von einem Element der Mikroschaltung mittels Schallquanten auf andere Elemente übertragen. Das verursacht unerwünschte Effekte. Um den normalen Betrieb sicherzustellen, darf die Erhitzung 102 W/cm$^2$ nicht überschreiten. Schätzungsweise führt das insbesondere zur Begrenzung des Informationsspeichers bis zu (4-10) Mbit/cm$^2$ [N.V. Agrinskaya, Molekularelektronik, Lehrwerk].

Im Zusammenhang mit den oben beschriebenen Problemen der Dimensionierung der traditionellen Siliziumgeräte wird heutzutage eine umfassende Suche nach einer neuen Bauelementebasis und dementsprechendem Integrationsverfahren durchgeführt. Sie können der weiteren Entwicklung der Rechenleistung der Digitalsysteme zugrunde liegen. Nanoelektromechanische Systeme stellen eine der aussichtsreichsten Richtungen der Suche dar. Nanoelektromechanische Strukturen weisen auch ein großes Potential bei der Lösung der Aufgaben der Sensortechnik dar. In vielen Bereichen der menschlichen Tätigkeit besteht ein großer Bedarf an hochempfindlichen und selektiven Gassensoren. Abgesehen von der Empfindlichkeit und der Selektivität werden von den Sensoren auch solche Eigenschaften wie kleine Abmessungen, Zuverlässigkeit, lange Lebensdauer und Fähigkeit zur vielfachen Regeneration, geringer Energieverbrauch und niedriger Wert gefordert.

Zur Zeit sind die Gassensoren entweder auf der Basis der akustischen Oberflächenwellen oder auf der Basis der chemisch empfindlichen Feldeffekt-Transistoren besonders weit verbreitet. Diese Einrichtungen haben einen akzeptablen Preis, stellen jedoch keine Empfindlichkeitsschwelle von über 1 ng/mm$^2$ sicher.

Verschiedene Methoden für die Spektroskopie, z.B. Romanovskys Spektroskopie der Oberflächenstreuung, stellen eine Empfindlichkeit bis 1 pg/mm$^2$ sicher. Jedoch setzen sie den Einsatz von komplizierten optischen Systemen und begleitender Ausrüstung voraus und sind dementsprechend sehr teuer. Chromatografische Verfahren zur Messung von Dampf- und Gaskonzentrationen bedürfen komplizierter und aufwändiger Ausrüstung, und ihre Anwendung ist fachlich sehr spezifisch. [US5719324].

Eine der aussichtsreichsten Richtungen sind die Geber auf der Basis des mikroelektromechanischen Aufnahmeelements. Der typische Aufbau eines solchen Gebers umfasst einen Piezowandler, Mittel zur Erregung des Piezowandlers und Mittel zur Schwingungserkennung. Auf dem Piezowandler ist ein Balkenelement (in der Regel Siliziumbalken) auskragend befestigt. Die Erregung des Piezowandlers erfolgt mit Resonanz- oder Nebenresonanzfrequenz des auskragend befestigten Balkenelements. Die Schwingungserkennungsmittel dienen zur Messung der Schwingungsfrequenzänderung des Balkenelements infolge der Änderung seiner Festigkeitskonstante als Ergebnis der Gasadsorption [US5719324].

Die Mängel der Einrichtungen dieses Typs sind wie folgt:

- Kompliziertheit der Aufgabe zur Messung der Schwingungsfrequenz des Balkenelements. Das bekannte Messverfahren mittels Erkennung der Verschiebung des vom Balkenelement reflektierten Laserstrahls erhöht drastisch die Dimensionen, die Kompliziertheit und den Aufwand der gesamten Einrichtung. Als Alternativverfahren zur Messung der Schwingungsfrequenz kann ein Verfahren dienen, welches auf elektrischer Kapazitätsmodulation des Systems Balkenelement - Festelektrode beruht. Jedoch hängt die Empfindlichkeit dieses Verfahrens sehr von der gegenseitigen Lage des Balkenelements und der Festelektrode ab. Die Vergrößerung des Abstands dazwischen führt zu einer schnellen Empfindlichkeitsabnahme. Andererseits verschärft die Verminderung des Abstands zwischen dem Balkenelement und der Festelektrode die Anforderungen an das Fertigungsverfahren der Einrichtung und begrenzt den Bereich der zulässigen Schwingungsweitenänderung des Balkenelements. Die piezoelektrischen und piezoresistiven Verfahren zur Ermittlung der Schwingungsfrequenz sind möglicherweise aussichtsreicher. Jedoch hängt die dadurch sichergestellte Empfindlichkeit von der konkreten technischen Ausführung ab, und bei geringen Schwingungen des Balkenmikroelements kann sie ungenügend sein.

- Die geometrischen Abmessungen des Balkenelements sind durch die Möglichkeiten der modernen MEMS-Technologie begrenzt. Wenn es sich um die Elemente mit einer Flachgeometrie handelt, z.B. Balken oder Membranen, so ist ihre Mindestdicke mit einer Größe von 500 nm begrenzt. Die Empfindlichkeit der Resonanzschwingungsfrequenz des Balkenelements gegenüber der Einwirkung von Gasadsorbat ist zur spezifischen Fläche dieses Elements proportional. In diesem Fall ist diese Fläche der Dicke des Elements indirekt proportional. Darüber hinaus verursachen die durch die geometrischen Balkendimensionen bedingten Einschränkungen in Bezug auf Resonanzfrequenz und Gütefaktor eine Empfindlichkeitsherabsetzung des Sensors.

- Die Selektivität der Gaserkennung wird dadurch sichergestellt, dass das Balkenelement Bereiche mit einer Oberfläche enthält, die durch eine bestimmte chemische Reagens behandelt (funktionalisiert) sind. Dieses Reagens stellt eine selektive Zusammenwirkung mit bestimmten Gasarten sicher. Die allgemeine Aufgabe der Suche nach einem solchen chemischen Reagens, das mit verschiedenen praktisch wichtigen Gasen selektiv und zudem umkehrbar reagiert, sowie die Aufgabe des Funktionalisierens der Festkörperoberfläche mittels dieses Reagens ist an und für sich sehr kompliziert und zur Zeit nicht zufriedenstellend lösbar.

- Es sind keine Mittel zur Kontrolle des Regenerationsverlaufs des sensorischen Vermögens des Aufnahmeelements vorgesehen.

Für die oben genannten Anwendungen (und zwar analoge und digitale Signalverarbeitung, Sensorik) sind unterschiedliche elektromechanische Strukturen bekannt, deren Funktionselemente im Nanomaßstab ausgebildet sind. Insbesondere wurde vorgeschlagen, als zustandsgesteuerte Elemente Kohlenstoffnanoröhrchen einzusetzen. Diese Kohlenstoffnanoröhrchen sind mechanisch auf diese oder jede Weise frei beweglich [W002080360, W00103208, US2002167375, EP1646145, CA2581248, US2007063740, W02007030423]. Jedoch haben die Entwickler an diesen Beispielen das Potential der Selbstorganisationsabläufe im Zusammenhang mit der Herstellung von Kohlenstoffnanoröhrchen ausgenutzt. Bei weiteren Schritten der Strukturenherstellung wenden sich die Entwickler an die traditionelle und ihren Möglichkeiten nach sehr begrenzte Lithografie, oder sie schneiden das Problem der Mittel zur Ausbildung der vorgeschlagenen Strukturen überhaupt nicht an.

Es ist Aufgabe der Erfindung, eine nanoelektromechanische Funktionsstruktur zu entwickeln und ein Verfahren zu ihrer Herstellung anzugeben. Die Struktur und das Verfahren ermöglichen es, die genannten Mängel der mikroelektronischen und Sensorsysteme, die den Stand der Technik darstellen, zu überwinden, die Integrationsstufe und die Betriebsfrequenz zu erhöhen, die Kenndatenfluktuationen der Elemente zu verringern, ihre temporäre und radioaktive Stabilität zu erhöhen, die Empfindlichkeit und die Selektivität gegenüber den physikalischen und den chemischen Einwirkungen zu erhöhen und die Selbstkosten der hergestellten Systeme zu verringern.

Die gestellte Aufgabe wird durch die Merkmale des Anspruchs 1 und des Anspruchs 24 gelöst.

Das technische Ergebnis, welches bei der Ausführung der Erfindung erreicht wird, ist wie folgt:

- die Herstellung einer Funktionsstruktur gemäß einer der Ausführungen der Erfindung.

Diese Funktionsstruktur stellt das Erreichen einer hohen Integrationsstufe (bis $10^{16}$ m$^{-2}$ und höher) sicher und zwar durch die Erfüllung von zwei Bedingungen:

a) Der Strukturherstellung liegen Mechanismen für die Selbstorganisation und die Selbstjustierung zugrunde. Deswegen haben die wesentlichen Geometriekennwerte der Strukturen keine Begrenzungen in Bezug auf die technischen Möglichkeiten der traditionellen Photolithografie.

b) Reproduzierbarkeit und Funktionsfähigkeit der Strukturen bleiben bei maximal höchsten Integrationsstufen erhalten.

- Sicherstellung des nichtflüchtigen Speichers gemäß einer der Ausführungen der Erfindung. Der Speicher ist durch eine hohe Integrationsstufe, eine beachtliche Minderung der Oberflächendichte der erforderlichen Verbindungswege sowie durch eine supergroße Bestrahlungsbeständigkeit gekennzeichnet.

- Sicherstellung eines Gasgebers gemäß einer der Ausführungen der Erfindung:

Der Gasgeber weist eine hohe Empfindlichkeit bei der Konzentrationsmessung von bestimmten Gasen oder Teilchen in der Atmosphäre, universelle und flexible Selektivitätsmechanismen, eine kontrollierbare Regeneration des sensorischen Vermögens, ein fertigungstechnisch einfaches Verfahren zur Erzeugung von messbaren Signalen und dementsprechend kleine Dimensionen und Verbrauchskennwerte der gesamten Einrichtung auf.

Das genannte technische Ergebnis wird in der Struktur für die Anwendungen in der Sensortechnik und Mikroelektronik erreicht. Diese Struktur umfasst:

- wenigstens ein steuerbares stromleitfähiges Element;

- wenigstens eine Eingangselektrode, die im elektrischen Kontakt mit dem steuerbaren Element steht;

- wenigstens eine Ausgangselektrode, die von dem steuerbaren Element räumlich getrennt ist und die mit dem steuerbaren Element elektrostatisch gekoppelt ist. Dabei ist entweder mindestens ein Teil der Ausgangselektrode aus einem Material ausgebildet, welches irreversible physikalische oder chemische Änderungen bei physikalischer oder chemischer und durch das steuerbare Element vermittelter Einwirkung bewirkt, oder mindestens ein Teil des steuerbaren Elements aus einem Material ausgebildet, welches irreversible physikalische oder chemische Änderungen bei physikalischer oder chemischer und durch die Ausgangselektrode vermittelter Einwirkung bewirkt.

Das steuerbare Element ist als ein elastisches Element ausgebildet, welches seine Geometrie ändern kann. Das elastische Element kann mechanische Schwingungen mit Eigenfrequenzen frei ausführen.
Das steuerbare Element enthält zusätzlich Mittel zur Erkennung des elektrischen Signals. Sie stehen im Signalverkehr mit wenigstens einer Ein- oder einer Ausgangselektrode. Das elastische Element kann in einen stabilen oder kurzzeitigen mechanischen Kontakt mit mindestens einer Ausgangselektrode übergehen. Dabei stellen die Mittel zur Erkennung des elektrischen Signals wenigstens die Erkennung der elektrischen Signaländerungen sicher, die mit diesem stabilen oder kurzfristigen mechanischen Kontakt zusammenhängen.
Mindestens ein Teil der Oberfläche von wenigstens einer Ausgangselektrode ist mit einer Isolier- oder leitfähigen Schicht versehen. Somit verhindert diese Isolier- oder leitfähige Schicht die Möglichkeit eines unmittelbaren mechanischen Kontakts zwischen dem elastischen Element und dieser Ausgangselektrode.
Das steuerbare Element enthält zusätzlich Mittel zur Versorgung mit einer Verschiebungsgleichspannung zwischen dem elastischen Element und der Ausgangselektrode bzw. zwischen der Kombination der Ausgangselektroden. Diese Mittel stellen eine Kontrolle der mechanischen Resonanzschwingungsfrequenz des elastischen Elements oder im Falle des mechanischen Kontakts des elastischen Elements mit wenigstens einer Ausgangselektrode sicher. Diese Mittel stellen auch eine Kontrolle des Verhältnisses der Kräfte sicher, die das steuerbare Element an die Ausgangselektrode anpressen, zu den Kräften, die den mechanischen Kontakt des steuerbaren Elements mit der Ausgangselektrode zu unterbrechen streben.
Die räumliche Trennung des elastischen Elements und wenigstens einer Ausgangselektrode oder die Oberflächeneigenschaften des elastischen Elements und dieser Ausgangselektrode oder die Verschiebungsspannung, welche zwischen dem elastischen Element und der Ausgangselektrode oder zwischen der Kombination der Ausgangselektrode angelegt ist, sind so vorgegeben, dass entweder der stabile oder der kurzfristige mechanische Kontakt des elastischen Elements mit dieser Ausgangselektrode sichergestellt ist.
Wenigstens ein Teil der Oberfläche des steuerbaren Elements ist chemisch oder biologisch funktionalisiert.
Die elastischen Elemente sind in Gruppen von elastischen Elementen vereinigt. Die elastischen Elemente in jeder Gruppe haben allgemeine Ein- und Ausgangselektroden. Zusätzlich sind die Mittel zur Adressierung der elastischen Elemente oder Untergruppen von elastischen Elementen eingeschlossen. Jedem elastischen Element oder jeder Untergruppe von elastischen Elementen in der Gruppe entspricht eine eigene Resonanzschwingungsfrequenz. Die Adressierungsmittel geben mittels Ein- und Ausgangselektroden die Gruppe von elastischen Elementen vor, der das adressierbare elastische Element oder die adressierbare Untergruppe von elastischen Elementen angehört. Auf diese Weise wird auch die Frequenz der Verschiebungswechselspannung vorgegeben, die an die Kombination der Ein- und Ausgangselektroden der vorgegebenen Gruppe von elastischen Elementen angelegt ist. Somit entspricht diese Frequenz der Frequenz der Resonanzschwingungen des adressierbaren elastischen Elements oder der Untergruppe von elastischen Elementen. Jedes elastische Element, wenn es im mechanischen Kontakt mit wenigstens einer Ausgangselektrode steht, kann mechanische Schwingungen mit eigener Frequenz ausführen. Diese Frequenz unterscheidet sich von der Eigenfrequenz dieses Elements, wenn kein mechanischer Kontakt vorliegt. Die Adressierungsmittel geben die Frequenz der Verschiebungswechselspannung vor, die an die Kombination der Ein- und Ausgangselektroden der vorgegebenen Gruppe von elastischen Elementen angelegt wird, so dass diese Frequenz der Resonanzschwingungsfrequenz des adressierbaren elastischen Elements im Zustand des mechanischen Kontakts entspricht oder so dass diese Frequenz der Resonanzschwingungsfrequenz des adressierbaren elastischen Elements bei fehlendem mechanischen Kon-

takt entspricht.

Die Adressierungsmittel geben die Verschiebungswechselspannung vor, die an die Kombination der Ein- und Ausgangselektroden der vorgegebenen Gruppe von elastischen Elementen angelegt wird, so dass diese Verschiebungsspannung die Überlagerung der Wechselspannungen darstellt, deren Frequenzen unterschiedlich sind.

Die Frequenz jeder dieser Spannungen entspricht der Resonanzschwingungsfrequenz eines der elastischen Elemente.

Das steuerbare Element stellt die Kohlenstoffnanoröhrchen oder Kohlenstoffnanofasern oder ein Bündel von Kohlenstoffnanoröhrchen oder von Kohlenstoffnanofasern dar.

Mindestens ein Teil der Ausgangselektrode ist aus einem Material auf Kohlenstoffbasis ausgebildet. Dieses Material erleidet irreversible physikalische oder chemische Änderungen bei physischer oder chemischer Einwirkung, die durch das steuerbare Element vermittelt wird.

Das steuerbare Element stellt ein mehrschichtiges Kohlenstoffnanoröhrchen dar. Wenigstens eine Außenschicht des Nanoröhrchens ist mittels der Einwirkung entfernt, die durch die Ausgangselektrode vermittelt wird.

Das oben genannte technische Ergebnis wird auch in einer anderen Ausführungsform der Struktur für Anwendungen in der Sensortechnik und der Mikroelektronik erreicht. Diese Struktur umfasst:

- wenigstens ein steuerbares Element, welches in Form eines elastischen, elektrisch leitfähigen und mechanisch mit Eigenfrequenz frei schwingbaren Elements ausgebildet ist;

- wenigstens eine Eingangselektrode, die mit dem elastischen Element in elektrischem Kontakt steht;

- wenigstens eine Ausgangselektrode, die vom elastischen Element räumlich getrennt ist und die mit dem steuerbaren Element elektrostatisch gekoppelt ist;

- die Mittel zur Anlegung einer Verschiebungsspannung zwischen der Kombination der Ein- und Ausgangselektroden;

- die Mittel zur Erkennung des elektrischen Signals. Sie stehen im Signalverkehr mit wenigstens einer Ein- oder einer Ausgangselektrode.

Dabei stellen die Versorgungsmittel der Verschiebungsspannung die Erregung von mechanischen Schwingungen des elastischen Elements sicher. Dabei hat die Amplitude der Resonanzschwingungen des elastischen Elements eine Größe, die den Übergang des elastischen Elements zum stabilen oder kurzen mechanischen Kontakt mit wenigstens einer Ausgangselektrode sicherstellt. Die Mittel zur Erkennung des elektrischen Signals stellen wenigstens die Erkennung der Änderungen des elektrischen Signals sicher, die mit diesem stabilen oder kurzen mechanischen Kontakt zusammenhängen.

Die elastischen Elemente sind in Gruppen von elastischen Elementen vereinigt. Die elastischen Elemente in jeder Gruppe haben allgemeine Ein- und Ausgangselektroden. Zusätzlich sind Mittel zur Adressierung der elastischen Elemente oder Untergruppen von elastischen Elementen eingeschlossen. Jedem elastischen Element oder jeder Untergruppe von elastischen Elementen in der Gruppe entspricht eine eigene Resonanzschwingungsfrequenz. Die Adressierungsmittel geben mittels Ein- und Ausgangselektroden die Gruppe von elastischen Elementen vor, der das adressierbare elastische Element oder die adressierbare Untergruppe von elastischen Elementen angehört. Auf diese Weise wird auch die Frequenz der Verschiebungswechselspannung vorgegeben, die an die Kombination der Ein- und Ausgangselektroden der vorgegebenen Gruppe von elastischen Elementen angelegt wird. Somit entspricht diese Frequenz der Frequenz der Resonanzschwingungen des adressierbaren elastischen Elements oder der Untergruppe von elastischen Elementen. Jedes elastische Element, wenn es im mechanischen Kontakt mit wenigstens einer Ausgangselektrode steht, kann mechanische Schwingungen mit eigener Frequenz ausführen. Diese Frequenz unterscheidet sich von der Eigenfrequenz dieses Elements, wenn kein mechanischer Kontakt vorliegt. Die Adressierungsmittel geben die Frequenz der Verschiebungswechselspannung vor, die an die Kombination der Ein- und Ausgangselektroden der vorgegebenen Gruppe von elastischen Elementen angelegt wird, so dass diese Frequenz der Resonanzschwingungsfrequenz des adressierbaren elastischen Elements im Zustand des mechanischen Kontakts entspricht oder so dass diese Frequenz der Resonanzschwingungsfrequenz des adressierbaren elastischen Elements bei fehlendem mechanischen Kontakt entspricht.

Die Adressierungsmittel geben eine Verschiebungswechselspannung vor, die an die Kombination der Ein- und Ausgangselektroden der vorgegebenen Gruppe von elastischen Elementen angelegt wird, so dass diese Verschiebungsspannung die Überlagerung der Wechselspannungen darstellt, deren Frequenzen unterschiedlich sind. Die Frequenz jeder dieser Spannungen entspricht der Resonanzschwingungsfrequenz eines der elastischen Elemente.

Diese Struktur umfasst zusätzlich mindestens eines der folgenden Mittel:

- Mittel zur Kontrolle der Desorptionsgeschwindigkeit der Gasmoleküle auf der Oberfläche von mindestens einem elastischen Element, sie enthalten Mittel, die den elektrischen Strom über dieses elastische Element durchlassen, oder sie enthalten einen zu diesem elastischen Element externen Erhitzer oder eine elektromagnetische Strahlungsquelle;

- Mittel zur Bestimmung der Verhältnisse zwischen den Verschiebungswerten der Resonanzschwingungsfrequenz von mindestens einem elastischen Element. Hier hängt diese Verschiebung mit der Größenänderung des über dieses elastische Element fließenden elektrischen Stroms oder der Erhitzungs- oder Strahlungsintensität dieses elastischen Elements durch die externe Quelle zusammen;

- Mittel zur Messung von dynamischen oder statischen Stromspannungskennlinien des Stromkreises. Der Stromkreis schließt mindestens eine Eingangselektrode, eine Ausgangselektrode und ein elastisches Element ein oder

- Mittel zur Erkennung der Änderung dieser Stromspannungskennlinien oder der Änderung der Hysterese dieser Stromspannungskennlinien;

- Mittel zur Erkennung der Adhäsionskraft zwischen mindestens einem elastischen Element und mindestens einer Ausgangselektrode. Diese Mittel erkennen die Größe des elektrischen Potentials, welches an dieses elastische Element und an die bestimmte Ausgangselektrode bzw. die Kombination der Ausgangselektroden angelegt werden muss, um den Kontakt zwischen diesem elastischen Element und dieser Ausgangselektrode zu unterbrechen;

- Mittel zur Erkennung des Schwellenwertes bei der Elektronenemission durch mindestes ein elastisches Element oder Mittel zur Erkennung der Änderung dieser Emissionsschwelle;

- Mittel zur Erkennung der Resonanzschwingungsfrequenzverschiebung von mindestes einem elastischen Element. Hier ist diese Verschiebung durch die Änderung des Widerstands bedingt, welchen die Umgebung des elastischen Elements seiner Bewegung leistet;

- Mittel, die für die vorgegebenen Gastypen den vorrangigen Zugang zu wenigstens einem elastischen Element sicherstellen. Diese Mittel setzen den Einsatz von Materialien mit selektiver Durchlassfähigkeit voraus.

Wenigstens ein Teil der Oberfläche des elastischen Elements ist chemisch oder biologisch funktionalisiert.
Diese Struktur umfasst zwei oder mehr elastische Elemente, die sich nach der Länge oder nach dem effektiven Durchmesser oder nach der Struktur oder nach den Kennwerten der Oberflächenfunktionalisierung unterscheiden. Sie enthält auch zusätzlich Mittel zur Ermittlung der Verhältnisse zwischen den Resonanzschwingungsfrequenzverschiebungen dieser elastischen Elemente. Hier ist diese Verschiebung durch die physikalische oder chemische Sorption der Moleküle oder der Teilchen durch diese elastischen Elemente bedingt.
Die Struktur umfasst zwei oder mehr elastische Elemente. Dabei ist wenigstens ein Teil der elastischen Elemente baulich gegen eine Belichtung aus der Umgebung geschützt. Die Struktur enthält auch zusätzlich Mittel, die die Verschiebung der Resonanzschwingungsfrequenz der elastischen und gegen die Belichtung baulich geschützten Elemente festlegen. Diese Verschiebung ist durch die Temperaturänderung dieser elastischen Elemente infolge der Temperaturänderung der Umgebung oder infolge des Stromflusses durch diese Elemente bedingt.
Das elastische Element stellt ein Kohlenstoffnanoröhrchen oder eine Kohlenstoffnanofaser oder ein Bündel von Kohlenstoffnanoröhrchen oder Kohlenstoffnanofasern dar.
Das oben genannte technische Ergebnis wird gemäß einem Verfahren zur Herstellung von Strukturen für die Anwendungen in der Sensortechnik und Mikroelektronik erreicht. Dieses Verfahren umfasst:

- Ausbildung von wenigstens einem steuerbaren Element und wenigstens einer Ausgangselektrode, so dass entweder mindestens ein Teil der Ausgangselektrode aus einem Material ausgeführt wird, welches irreversible physikalische oder chemische Änderungen bei einer physikalischen oder chemischen durch das steuerbare Element vermittelten Einwirkung bewirkt; oder mindestens ein Teil des steuerbaren Elements aus einem Material ausgebildet wird, welches irreversible physikalische oder chemische Änderungen bei physikalischer oder chemischer und durch die Ausgangselektrode vermittelter Einwirkung bewirkt;

- Ausführung eines der folgenden Vorgänge:

  - entweder Änderung der Materialeigenschaften der Ausgangselektrode im lokalen Bereich an der Trenngrenze Ausgangselektrode - steuerbares Element. In diesem Bereich wird diese Änderung der Eigenschaften durch die physikalische oder chemische und durch das steuerbare Element vermittelte Einwirkung ausgelöst,

- oder eine Änderung der Materialeigenschaften des steuerbaren Elements im lokalen Bereich an der Trenngrenze steuerbares Element - Ausgangselektrode. In diesem Bereich wird diese Änderung der Eigenschaften durch die physikalische oder chemische und durch die Ausgangselektrode vermittelte Einwirkung hervorgerufen. Als steuerbares Element dient ein Kohlenstoffnanoröhrchen, welches auf einem Träger senkrecht befestigt wird. Als Ausgangselektrode wird eine Schicht aus einem Material auf Kohlenstoffbasis verwendet.

Als Eigenschaftsänderungsvorgang des Materials der Ausgangselektrode gilt das Verfahren der lokalen anodischen Oxidation. Dabei wirkt das steuerbare Element als Kathode und die Ausgangselektrode als Anode. Als Resultat wird eine Oxidation der Ausgangselektrode im lokalen Bereich rings um das steuerbare Element erreicht.

Als steuerbares Element dient ein mehrschichtiges Kohlenstoffnanoröhrchen, welches auf einem Träger senkrecht befestigt wird. Als Ausgangselektrode wird eine Schicht eines chemisch inerten leitfähigen Materials verwendet. Als Eigenschaftsänderungsvorgang des Materials des steuerbaren Elements wird die lokale anodische Oxidation verwendet. Dabei wirkt das steuerbare Element als Anode und die Ausgangselektrode als Kathode. Im Endeffekt wird die Oxidation von wenigstens einer Außenschicht des mehrschichtigen Kohlenstoffnanoröhrchens erreicht.

Das oben genannte technische Ergebnis wird gemäß einer anderen Ausführungsform des Verfahrens zur Herstellung von Strukturen für die Anwendungen in der Sensortechnik und Mikroelektronik erreicht. Das Verfahren umfasst:

- Ausbildung von wenigstens einem steuerbaren Element und wenigstens einer Ausgangselektrode, so dass als steuerbares Element ein Nanoröhrchen oder eine Nanofaser oder ein Bündel von Nanoröhrchen oder Nanofasern verwendet wird. Dabei wird mindestens ein Teil der Oberfläche des steuerbaren Elements mit einem Material beschichtet, welches sich seinen Eigenschaften nach sowohl vom Material des steuerbaren Elements als auch vom Material der Ausgangselektrode unterscheidet;

- teilweise oder vollständige Entfernung der Schicht des Materials, welches auf die Oberfläche des steuerbaren Elements aufgetragen worden ist und sich seinen Eigenschaften nach sowohl vom Material des steuerbaren Elements als auch vom Material der Ausgangselektrode unterscheidet.

Das Nanoröhrchen stellt das Kohlenstoffnanoröhrchen dar, welches auf einem Träger senkrecht befestigt wird. Als die Schicht des Materials, welches mindestens auf einen Teil der Oberfläche des steuerbaren Elements aufgetragen wird und sich seinen Eigenschaften nach sowohl vom Material des steuerbaren Elements als auch von dem der Ausgangselektrode unterscheidet, wird eine molekulare Monoschichtbelegung verwendet. Diese Monoschicht wurde infolge des Selbstorganisationsvorgangs ausgebildet. Als Vorgang zur teilweisen bzw. vollständigen Entfernung dieser molekularen Monoschicht wird selektives Ätzen verwendet.

Die Erfindung wird anhand von in den Zeichnungen dargestellten Ausführungsformen von Strukturen näher erläutert. Es zeigen:

Fig. 1    die schematische Darstellung einer Ausführungsform der Struktur auf der Ba- sis von Kohlenstoffnanoröhrchen für verschiedene Anwendungen in der Sen- sortechnik und der Mikroelektronik,

Fig. 2    die schematische Darstellung einer Ausführungsform der Struktur auf der Ba- sis von Kohlenstoffnanoröhrchen für verschiedene Anwendungen in der Sen- sortechnik und der Mikroelektronik für den Fall, wenn ein mechanischer Kon- takt zwischen dem elastischen Element und der Ausgangselektrode vorliegt,

Fig. 3    die schematische Darstellung einer Ausführungsform der Struktur auf der Ba- sis von Kohlenstoffnanoröhrchen für verschiedene Anwendungen in der Sen- sortechnik und der Mikroelektronik für den Fall, wenn die Ausgangselektrode mit einer Isolier- oder leitfähigen Schicht versehen ist,

Fig. 4    die schematische Darstellung einer Ausführungsform der Struktur auf der Ba- sis von Kohlenstoffnanoröhrchen für verschiedene Anwendungen in der Sen- sortechnik und der Mikroelektronik für den Fall, wenn eine zusätzliche Elektro- de vorhanden ist,

Fig. 5    die schematische Darstellung einer Ausführungsform der Struktur auf der Ba- sis von Kohlenstoffnanoröhrchen für verschiedene Anwendungen in der Sen- sortechnik und der Mikroelektronik für den Fall, wenn eine Vielzahl von Grup- pen von elastischen Elementen vorhanden ist,

Fig. 6    die schematische Darstellung der Zwischenphase innerhalb des Vorgangs zur Ausbildung einer Struktur, welche der Ausführungsform der Struktur auf der Basis von Kohlenstoffnanoröhrchen für verschiedene Anwendungen in der Sensortechnik und der Mikroelektronik entspricht und

Fig. 7   die schematische Darstellung der Endphase innerhalb des Vorgangs zur Aus- bildung einer Struktur, welche der Ausführungsform der Struktur auf der Basis von Kohlenstoffnanoröhrchen für verschiedene Anwendungen in der Sensor- technik und der Mikroelektronik entspricht.

Die Struktur für verschiedene Anwendungen in der Sensortechnik und Mikroelektronik umfasst:

- wenigstens ein steuerbares, stromleitfähiges Element 2;

- wenigstens eine Eingangselektrode 3, die im elektrischen Kontakt mit dem steuerbaren Element 2 steht;

- wenigstens eine Ausgangselektrode 5, die von dem steuerbaren Element 2 räumlich getrennt ist und die mit dem steuerbaren Element 2 elektrostatisch gekoppelt ist. Dabei ist entweder wenigstens ein Teil der Ausgangselektrode 5 aus einem Material ausgebildet, welches irreversible physikalische oder chemische Änderungen bei physikalischer oder chemischer durch das steuerbare Element 2 vermittelter Einwirkung bewirkt, oder wenigstens ein Teil des steuerbaren Elements 2 ist aus einem Material ausgebildet, welches irreversible physikalische oder chemische Änderungen bei physikalischer oder chemischer durch die Ausgangselektrode 5 vermittelter Einwirkung bewirkt.

Das steuerbare Element 2 kann als ein elastisches Element ausgebildet sein, welches seine Geometrie ändern und mechanische Schwingungen auf eigenen Frequenzen frei ausführen kann.

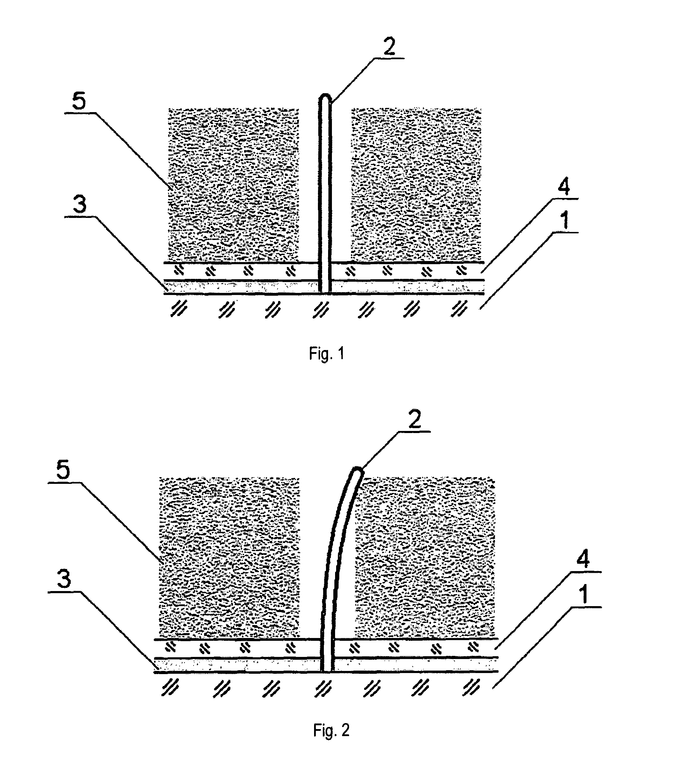

Die Struktur kann zusätzlich Mittel zur Erkennung des elektrischen Signals einschließen. Diese Mittel stehen im Signalverkehr mit wenigstens einer Eingangselektrode 3 oder Ausgangselektrode 5 im Kontakt. Das elastische Element 2 kann einen stabilen oder kurzzeitigen mechanischen Kontakt mit wenigstens einer Ausgangselektrode 5 bewirken (Fig. 2). Dabei stellen die Mittel zur Erkennung des elektrischen Signals wenigstens eine Erkennung der elektrischen Signaländerungen sicher, die mit diesem stabilen oder kurzfristigen mechanischen Kontakt zusammenhängen.

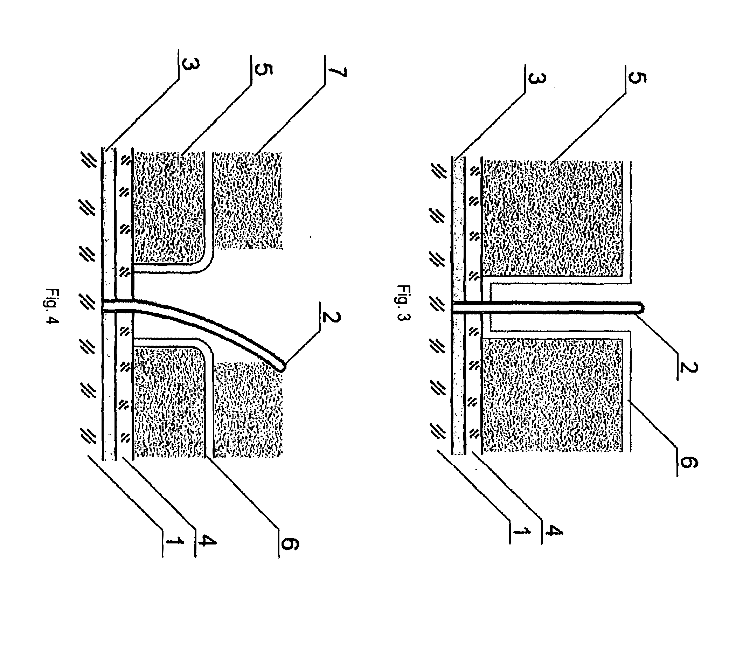

Wenigstens ein Teil der Oberfläche von wenigstens einer Ausgangselektrode 5 kann mit einer Isolier- oder leitfähigen Schicht 6 versehen sein (Fig. 3). In diesem Fall verhindert diese Isolier- oder leitfähige Schicht 6 die Möglichkeit eines unmittelbaren mechanischen Kontakts zwischen dem elastischen Element 2 und dieser Ausgangselektrode 5.

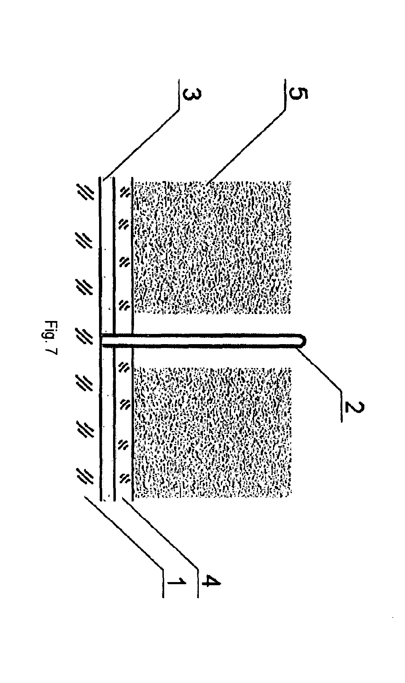

Die Struktur kann zusätzlich Mittel zum Anlegen einer Verschiebungsgleichspannung zwischen dem elastischen Element 2 und der Ausgangselektrode 5 einschließen (oder z.B. der Ausgangselektrode 5 oder 7 in Fig. 4). Dies kann auch eine Kombination von Ausgangselektroden sein. Diese Mittel stellen eine Frequenzkontrolle der mechanischen Resonanzschwingungen des elastischen Elements 2 sicher. Oder im Falle der mechanischen Kopplung des elastischen Elements 2 mit wenigstens einer Ausgangselektrode ( 5 in Fig. 1 oder 7 in Fig. 2) stellen diese Mittel eine Kontrolle des Verhältnisses der Kräfte sicher, die das steuerbare Element 2 an die Ausgangselektrode 5 anpressen, zu den Kräften, die den mechanischen Kontakt des steuerbaren Elements 2 mit der Ausgangselektrode 5 zu unterbrechen streben.

Gemäß einer der Ausführungsformen der vorgeschlagenen Erfindung sind

- die räumliche Trennung des elastischen Elements 2 und wenigstens einer Ausgangselektrode 5 (Fig. 1) oder

- die Oberflächeneigenschaften des elastischen Elements 2 und dieser Ausgangselektrode 5 oder

- die Verschiebungsspannung, welche zwischen dem elastischen Element 2 und der Ausgangselektrode 5 oder zwischen der Kombination der Ausgangselektroden angelegt ist,

so vorgegeben, dass entweder der stabile oder der kurzfristige mechanische Kontakt des elastischen Elements 2 mit dieser Ausgangselektrode 5 sichergestellt ist.

Wenigstens ein Teil der Oberfläche des steuerbaren Elements 2 kann chemisch oder biologisch funktionalisiert sein.

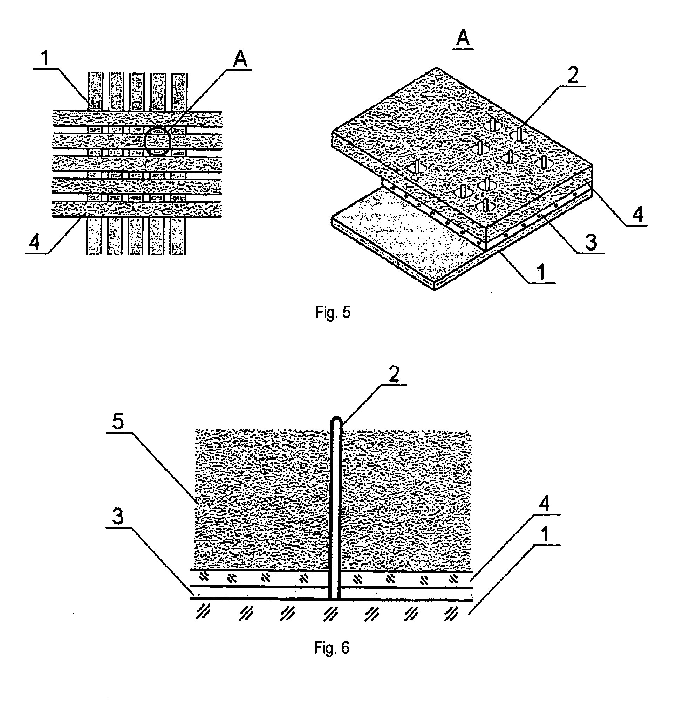

Gemäß einer der Ausführungsformen der vorgeschlagenen Erfindung sind elastische Elemente 2 (Fig. 5) zu Gruppen von elastischen Elementen vereinigt. Die elastischen Elemente 2 in jeder Gruppe weisen gemeinsame Eingangselektroden 1 und Ausgangselektroden 4 auf. Zusätzlich sind Mittel zur Adressierung der elastischen Elemente 2 oder Untergruppen von elastischen Elementen 2 eingeschossen. Jedem elastischen Element 2 oder jeder Untergruppe von elastischen Elementen 2 in der Gruppe entspricht eine eigene Resonanzschwingungsfrequenz. Die Adressierungsmittel geben mittels Ein- und Ausgangselektroden die Gruppe von elastischen Elementen 2 vor, der das adressierbare elastische Element 2 oder die adressierbare Untergruppe von elastischen Elementen 2 angehört. Auf diese Weise ist auch die Frequenz der Verschiebungswechselspannung vorgegeben, die an die Kombination der Ein- und Ausgangselektroden der vorgegebenen Gruppe von elastischen Elementen angelegt ist. Somit entspricht diese Frequenz der Frequenz der Resonanzschwingungen des adressierbaren elastischen Elements oder der Untergruppe von elastischen Elementen.

Gemäß einer der Ausführungsformen der vorgeschlagenen Erfindung kann jedes elastische Element 2 (Fig. 4), welches im mechanischen Kontakt mit wenigstens einer Ausgangselektrode 7 steht, mechanische Schwingungen mit eigener Frequenz frei ausführen. Diese Frequenz unterscheidet sich von der Eigenfrequenz dieses Elements, wenn kein mechanischer Kontakt vorliegt. Die Adressierungsmittel geben dabei die Frequenz der Verschiebungswechselspannung vor, die an die Kombination der Ein- und Ausgangselektroden der vorgegebenen Gruppe von elastischen Elementen 2 angelegt wird, so dass diese Frequenz der Resonanzschwingungsfrequenz des adressierbaren elastischen Elements 2 im Zustand des mechanischen Kontakts entspricht oder so dass diese Frequenz der Resonanzschwingungsfrequenz des adressierbaren elastischen Elements 2 bei keinem mechanischen Kontakt entspricht.

Gemäß einer der Ausführungsformen der vorgeschlagenen Erfindung geben die Adressierungsmittel die Verschiebungsspannung vor, die an die Kombination der Eingangselektroden 1 (Fig. 5) und der Ausgangselektroden 4 der vorgegebenen Gruppe der elastischen Elemente 2 angelegt wird, so dass diese Verschiebungsspannung die Überlagerung der Wechselspannungen darstellt, deren Frequenzen unterschiedlich sind. Die Frequenz jeder dieser Spannungen entspricht der Resonanzschwingungsfrequenz eines der elastischen Elemente 2.

Gemäß einer der Ausführungsformen der vorgeschlagenen Erfindung stellt das steuerbare Element 2 (Fig. 1) ein Kohlenstoffnanoröhrchen oder eine Kohlenstoffnanofaser oder ein Bündel von Kohlenstoffnanoröhrchen oder Kohlenstoffnanofasern dar. Mindestens ein Teil der Ausgangselektrode 5 ist aus einem Material auf Kohlenstoffbasis ausgebildet. Dieses Material erleidet irreversible physikalische oder chemische Änderungen bei physikalischer oder chemischer Einwirkung, die durch das steuerbare Element 2 vermittelt wird.

Gemäß einer der Ausführungsformen der vorgeschlagenen Erfindung stellt das steuerbare Element 2 ein mehrschichtiges Kohlenstoffnanoröhrchen dar. Wenigstens eine Außenschicht des Nanoröhrchens ist mittels Einwirkung entfernt, die durch die Ausgangselektrode 5 vermittelt wird.

Gemäß einer der Ausführungsformen der vorgeschlagenen Erfindung umfasst die Struktur zusätzlich wenigstens eines der folgenden Mittel:

- Mittel zur Kontrolle der Desorptionsgeschwindigkeit der Gasmoleküle von der Oberfläche von mindestens einem elastischen Element 2. Sie enthalten Mittel, die den elektrischen Strom über dieses elastische Element 2 durchlassen, oder sie enthalten einen zu diesem elastischen Element 2 externen Erhitzer oder eine elektromagnetische Strahlungsquelle;

- Mittel zur Bestimmung der Verhältnisse zwischen den Verschiebungswerten der Resonanzschwingungsfrequenz von mindestens einem elastischen Element 2. Hier hängt diese Verschiebung mit der Größenänderung des über dieses elastische Element 2 fließenden elektrischen Stroms oder der Erhitzungs- oder Strahlungsintensität dieses elastischen Elements 2 durch die externe Quelle zusammen;

- Mittel zur Messung von dynamischen oder statischen Stromspannungskennlinien des Stromkreises. Der Stromkreis schließt mindestens eine Eingangselektrode 3, eine Ausgangselektrode 5 und ein elastisches Element 2 ein oder

- Mittel zur Erkennung der Änderung dieser Stromspannungskennlinien oder der Änderung der Hysterese dieser Stromspannungskennlinien;

- Mittel zur Erkennung der Adhäsionskraft zwischen mindestens einem elastischen Element 2 und mindestens einer Ausgangselektrode 5 (oder Elektrode 7 in Fig. 4). Diese Mittel erkennen die Größe des elektrischen Potentials, welches an dieses elastische Element 2 und an die bestimmte Ausgangselektrode 5 (oder Elektrode 5 oder 7 in Fig. 4) oder die Kombination der Ausgangselektroden angelegt werden muss, um den Kontakt zwischen diesem elastischen Element 2 und dieser Ausgangselektrode 5 (oder Elektrode 7 in Fig. 4) zu unterbrechen;

- Mittel zur Erkennung des Schwellenwertes bei der Elektronenemission durch mindestes ein elastisches Element 2 oder Mittel zur Erkennung der Änderung dieser Emissionsschwelle;

- Mittel zur Erkennung der Resonanzschwingungsfrequenzverschiebung von mindestes einem elastischen Element 2. Hier ist diese Verschiebung durch eine Änderung des Widerstands bedingt, welchen die Umgebung des elastischen Elements 2 seiner Bewegung leistet;

- Mittel, die für die vorgegebenen Gastypen den vorrangigen Zugang zu wenigstens einem elastischen Element 2 sicherstellen. Diese Mittel setzen den Einsatz von Materialien mit selektiver Durchlassfähigkeit voraus.

Gemäß einer der Ausführungsformen der vorgeschlagenen Erfindung schließt die Struktur zwei oder mehr elastische Elemente 2 (Fig. 1) ein, die sich nach der Länge oder nach dem effektiven Durchmesser oder nach der Struktur oder nach den Kennwerten der Oberflächenfunktionalisierung unterscheiden. Diese Struktur enthält auch zusätzlich Mittel zur Ermittlung der Verhältnisse zwischen den Resonanzschwingungsfrequenzverschiebungen dieser elastischen Elemente. Hier ist diese Verschiebung durch die physikalische oder chemische Sorption der Moleküle oder der Teilchen durch diese elastischen Elemente bedingt.

Gemäß einer der Ausführungsformen der vorgeschlagenen Erfindung umfasst die Struktur zwei oder mehr elastische Elemente 2. Dabei ist wenigstens ein Teil der elastischen Elemente 2 baulich gegen die Belichtung aus der Umgebung geschützt. Die Struktur schließt zusätzlich Mittel ein, die die Verschiebung der Resonanzschwingungsfrequenz der elastischen und gegen die Belichtung baulich geschützten Elemente festlegen. Diese Verschiebung ist durch die Temperaturänderung dieser elastischen Elemente 2 infolge der Temperaturänderung der Umgebung oder infolge des Stromflusses durch diese Elemente bedingt.

Das Verfahren zur Herstellung der Struktur für verschiedene Anwendungen in der Sensortechnik und Mikroelektronik umfasst:

- die Ausbildung von wenigstens einem steuerbaren Element 2 (Fig. 6) und wenigstens einer Ausgangselektrode 5, so dass entweder wenigstens ein Teil der Ausgangselektrode 5 aus einem Material ausgebildet wird, welches irreversible physikalische oder chemische Änderungen bei physikalischer oder chemischer durch das steuerbare Element 2 vermittelter Einwirkung ausführt oder wenigstens ein Teil des steuerbaren Elements 2 aus einem Material ausgebildet wird, welches irreversible physikalische oder chemische Änderungen bei physikalischer oder chemischer durch die Ausgangselektrode 5 vermittelter Einwirkung ausführt;

- Ausführung eines der folgenden Vorgänge:
  entweder Änderung der Materialeigenschaften der Ausgangselektrode 5 im lokalen Bereich an der Trenngrenze Ausgangselektrode 5 - steuerbares Element 2 (Fig. 7). In diesem Bereich wird diese Änderung der Eigenschaften durch die physikalische oder chemische und durch das steuerbare Element 2 vermittelte Einwirkung hervorgerufen oder

  Änderung der Materialeigenschaften des steuerbaren Elements 2 im lokalen Bereich an der Trenngrenze steuerbares Element 2 - Ausgangselektrode 5. In diesem Bereich wird diese Änderung der Eigenschaften durch die physikalische oder chemische und durch die Ausgangselektrode vermittelte Einwirkung hervorgerufen.

Gemäß einer der Ausführungsformen des im Rahmen dieser Erfindung vorgeschlagenen Verfahrens dient als steuerbares Element 2 ein Kohlenstoffnanoröhrchen, welches auf einem Träger 1 senkrecht befestigt wird. Als Ausgangselektrode 5 wird eine Schicht von Material auf Kohlenstoffbasis verwendet.. Als Eigenschaftsänderungsvorgang des Materials der Ausgangselektrode wird das Verfahren der lokalen anodischen Oxidation verwendet. Dabei wirkt das steuerbare Element 2 als Kathode und die Ausgangselektrode 5 als Anode. Als Resultat wird die Oxidation der Ausgangselektrode 5 im lokalen Bereich rings um das steuerbare Element 2 erreicht.

Gemäß einer der Ausführungsformen des im Rahmen dieser Erfindung vorgeschlagenen Verfahrens wird als steuerbares Element 2 ein mehrschichtiges Kohlenstoffnanoröhrchen verwendet, welches auf einem Träger 1 senkrecht befestigt wird. Als Ausgangselektrode 5 wird eine Schicht eines chemisch inerten, leitfähigen Materials verwendet. Als Eigenschaftsänderungsvorgang des Materials des steuerbaren Elements 2 gilt die lokale anodische Oxidation. Dabei wird das steuerbare Element 2 als Anode und die Ausgangselektrode 5 als Kathode verwendet. Im Endeffekt wird die Oxidation von wenigstens einer Außenschicht des mehrschichtigen Kohlenstoffnanoröhrchen erreicht.

Das Verfahren zur Herstellung einer Struktur für verschiedene Anwendungen in der Sensortechnik und Mikroelektronik umfasst:

Ausbildung von wenigstens einem steuerbaren Element 2 und wenigstens einer Ausgangselektrode 5, so dass das steuerbare Element 2 ein Nanoröhrchen oder eine Nanofaser oder ein Bündel von Nanoröhrchen oder Nanofasern darstellt. Dabei wird mindestens ein Teil der Oberfläche des steuerbaren Elements 2 mit einem Material beschichtet, welches sich seinen Eigenschaften nach sowohl vom Material des steuerbaren Elements als auch vom Material der Ausgangselektrode unterscheidet;

teilweise oder vollständige Entfernung der Schicht des Materials, welches auf die Oberfläche des steuerbaren Elements 2 aufgetragen worden ist und sich seinen Eigenschaften nach sowohl vom Material des steuerbaren Elements als auch vom Material der Ausgangselektrode unterscheidet.

Gemäß einer der Ausführungsformen des im Rahmen dieser Erfindung vorgeschlagenen Verfahrens stellt ein Nanoröhrchen 2 ein Kohlenstoffnanoröhrchen dar, welches auf dem Träger 1 senkrecht befestigt wird Als Schicht vom Material, welches wenigstens auf einem Teil der Oberfläche des steuerbaren Elements 2 aufgetragen wird und sich seinen Eigenschaften nach aufgetragen wird und sich seinen Eigenschaften nach sowohl vom Material des steuerbaren Elements als auch von dem der Ausgangselektrode unterscheidet, gilt eine molekulare Monoschichtbelegung. Diese Monoschicht wurde infolge des Selbstorganisationsvorgangs ausgebildet. Als Vorgang der teilweisen bzw. vollständigen Entfernung dieser molekularen Monoschicht wird selektives Ätzen verwendet.

**Ausführliche Beschreibung**

Der Durchmesser der Kohlenstoffnanoröhrchen beträgt 0,7 nm. Dabei kann das System auf der Basis von Kohlenstoffnanoröhrchen unterschiedliche mechanische Zustände aufweisen. Diese Zustände sind bei Raumtemperaturen sowie bei höheren Temperaturen stabil. Die Lösung des Problems der Ausbildung von Steuerelektroden, die den Nanoröhrchendimensionen angemessen sind, und die Lösung des topographischen Problems der Sicherstellung einer entsprechenden Anzahl von Verbindungswegen sollten eine Integrationsstufe von ca. $10^{16}$ m$^{-2}$ ermöglichen. Somit kann dicht an den grundlegenden Grenzwert der Integrationsstufe (wenigstens für den Fall mit Raumtemperaturen) herangetreten werden. Das Erreichen dieser Integrationsstufe wird als technisches Ergebnis eines der Aspekte der vorgeschlagenen Erfindung erklärt. In Bezug auf den genannten Aspekt der Erfindung ist eine Kombination der drei folgenden Faktoren bestimmend. Der primäre Vorgang gibt die Grundlagen für die Strukturgeometrie vor. Dieser Vorgang ist das Wachstum des Kohlenstoffnanoröhrchens. Die Hauptkennwerte dieses Kohlenstoffnanoröhrchens sind durch die grundlegenden physikalischen Einschränkungen wie Länge und Richtung der chemischen Verbindung zwischen den Kohlenstoffatomen festgelegt. Im nächsten Schritt werden physikalische Mechanismen betätigt. Diese physikalischen Mechanismen stellen die teilweise Translation der Geometrie des gezüchteten Kohlenstoffnanoröhrchens auf die Steuerelektrode sicher. Das ermöglicht es, den Effekt einer Selbstjustierung der Steuerelektrode zu erreichen und stellt die Minimierung des Abstands Steuerelektrode - Kohlenstoffnanoröhrchen dar. Der dritte Faktor ist der Einsatz von den nicht nur entsprechenden Steuerelektroden sondern auch der Frequenz des an diese Elektroden gegebenen Signals, um die einzelnen Nanoröhrchen zu adressieren. Das ermöglicht es, die Anzahl der erforderlichen unabhängigen Elektroden und Verbindungswege zu mindern. Im allgemeinen Fall können auch andere Gegenstände anstelle von Kohlenstoffnanoröhrchen eingesetzt werden. Diese Gegenstände können das Produkt der Selbstorganisationsvorgänge darstellen [Siliziumnanodrähte (Ongi Englander, Dane Christensen, Liwei Lin. Applied physics letters. 2003. Vol. 82, No. 26, P. 4797- 4799), Nanogurte auf Basis von Halbleiteroxide (Zhong Lin Wang, Zhengwei Pan. International Journal of Nanoscience. 2002. Vol. 1, No. 1, P. 41-51) u.a.m.]. Diese Gegenstände können auch nach dem traditionellen Lithografieverfahren hergestellt werden. Die aus den Selbstorganisationsvorgängen resultierenden Gegenstände sind nachfolgend mit dem allgemeinen Begriff Nanofaser bezeichnet (unabhängig von der _Beschaffenheit der Struktur selbst und der Zusammensetzung dieser Objekte).

Gemäß einer der Ausführungsformen der vorgeschlagenen Erfindung dient die lokale anodische Oxidation (LAO) als physikalischer Mechanismus zur Translation der Geometrie des Kohlenstoffnanoröhrchens auf die Steuerelektrode.

Eine der bekanntesten verfahrenstechnischen Anwendungen der abtastenden Atom-Kraft-Mikroskopie ist die Modifikation der Eigenschaften des Leiterträgers mittels Oxidation. Dabei wird diese Oxidation mittels der Sonde des Atom-Kraft-Mikroskops induziert. Somit hat die Oxidation einen lokalen Charakter [V.K. Nevolin. Sondengestützte Nanotechnologien in der Elektronik. Moskau. Technosfera, 2006]. Dabei wird eine hohe räumliche Auflösung erreicht. Sie wird durch die Sondengeometrie des Atom-Kraft-Mikroskops, nämlich durch den effektiven Radius ihrer Rundung festgelegt. Da der negative Pol der Verschiebungsspannung (Kathode) an die Sonde des Atom-Kraft-Mikroskops und der positive Pol (Anode) an den zu behandelnden Träger angelegt wird, stellt dieser Vorgang die anodische Oxidation dar. Damit die LAO ablaufen kann, muss eine Sauerstoffionenquelle vorhanden sein. Unter atmosphärischen Bedingungen übernimmt das natürliche Adsorbat der Luft von der Oberfläche die Rolle einer solchen Quelle. Es sei bemerkt, dass der der LAO ähnliche Effekt auch durch die Mittel einer abtastenden Tunnelmikroskopie erreicht werden kann. Dabei wird in diesem Fall die Sicherstellung einer hohen räumlichen Auflösung vereinfacht. [A.A. Stroganov. Thesen zu den Berichten an der Konferenz "Mikroelektronik und Informatik - 2005"].

Die Breite des ausgebildeten oxidierten Bereichs fällt in Bezug auf die Größenordnung mit dem Abrundungshalbmesser der Sonde zusammen. Deswegen setzt die Erhöhung der räumlichen Auflösung nach dem LAO-Verfahren den Einsatz von spitzeren Sonden voraus. Die Sonden mit dem an der Spitze befestigten Kohlenstoffnanoröhrchen bieten eine der aussichtsreichsten Lösungen für die Sondenmikroskopie sowohl in Bezug auf das Kriterium der Minimierung des Abrundungshalbmessers als auch in Bezug auf das Kriterium der Vergrößerung des Aspektverhältnisses der Sonde. Somit ist es normal, das Kohlenstoffnanoröhrchen als ortsfeste Analogielösung für die Sonde des Atom-Kraft-Mikroskops zu betrachten, wenn das Kohlenstoffnanoröhrchen auf einem Träger senkrecht befestigt ist. Wenn eine Leiterschicht aus einem bestimmten Material mit einem solchen Nanoröhrchen in Kontakt kommt, dann kann die Oxidation dieser Schicht in einem in Bezug auf das Nanoröhrchen lokalisierten Bereich angeregt werden, vorausgesetzt, dass zwischen dieser Schicht und dem Nanoröhrchen eine Verschiebungsspannung mit entsprechender Polarität angelegt wird. Dabei ist zu bemerken, dass, wenn die Oxidationsprodukte des Leiterschichtmaterials zu den flüchtigen Verbindungen gehören, keine zusätzlichen Verfahrensschritte ausgeführt werden müssen, um einen Abstand (Spiel) zwischen dem Nanoröhrchen und der leitfähigen Schicht zu bekommen. Als solches Material der Leiterschicht kann z.B. amorpher Kohlenstoff oder Graphitkohlenstoff betrachtet werden.

Das Kohlenstoffnanoröhrchen stellt gegenüber den genannten Materialien eine thermodynamisch bedeutend beständigere Form von Kohlenstoff dar. Im Zusammenhang damit liegt ein Bereich von Bedingungen vor, bei denen die lokale anodische Oxidation dieser Materialien zustande kommen wird, während das diesen Vorgang anregende Kohlenstoffnanoröhrchen stabil bleiben wird. Die Stabilität des Nanoröhrchens während der Oxidation wird auch dadurch gefördert, dass das Nanoröhrchen als Kathode wirkt.

Es wurden Versuche im Zusammenhang mit der lokalen anodischen Oxidation der Kohlenstoffnanoröhrchen [Yu.A. Chaplygin, V.K. Nevolin, S.V. Khartov. Berichte der Akademie für Wissenschaften, 2007, Band 412, Nr. 6, S. 1-4] und der Folien von Graphitkohlenstoff unter Einsatz der Atom-Kraft-Mikroskopie [A.A. Stroganov. Thesen zu den Berichten an der Konferenz «Mikroelektronik und Informatik - 2005». M.: MIET. 2005. S. 16] durchgeführt. Im Rahmen dieser Versuche wurde die Spannungsschwelle der Oxidation beobachtet. Dieser Schwellenwert betrug 3-4 V für eine Graphitkohlenstofffolie und 6 V für Kohlenstoffnanoröhrchen. Der Grenzfall beim Graphitkohlenstoff ist der tiefgezogene pyrolytische Graphit. Seine Anwendung als Material der Steuerelektrode wird zur Verminderung der Energiedissipation durch die Struktur während des Betriebs beitragen.

Im allgemeinen Fall kann als Material der Steuerelektrode ein beliebiges Material angewendet werden, welches irreversible physikalische oder chemische Änderungen bei irgendeiner Einwirkung seitens des steuerbaren Elements (nämlich des Kohlenstoffnanoröhrchens) bewirkt. (Unter Irreversibilität der Änderungen wird dabei nicht die absolute Nichtumkehrbarkeit gemeint, sondern nur der einmalige Charakter von konkreten Änderungen im Rahmen des Lebenszyklus der Struktur). Die Zusammensetzung des Materials der Steuerelektrode kann insbesondere einen Bestandteil enthalten, welcher als Oxidans wirkt und den Oxidationsverlauf sicherstellen wird. Dabei wird die Oxidation durch die Einwirkung des steuerbaren Elements entlang der gesamten Oberfläche des steuerbaren Elements einmalig angeregt (im Gegenteil zum oben betrachteten Fall: Hier wirkt der amorphe oder der Graphitkohlenstoff als oxidierbares Material. Die Oxidation kommt folgerichtig zustande, angefangen mit den oberen Schichten, die mit dem Luftadsorbat in Kontakt sind. Das Luftadsorbat spielt in diesem Fall die Rolle der Sauerstoffionenquelle). Das steuerbare Element kann die Änderungen des Steuerelektrodenmaterials mittels des elektrischen Stroms, des elektrischen Feldes, der Wärme- oder chemischen Einwirkung induzieren. (Insbesondere kann das steuerbare Element als Katalysator der chemischen Reaktion wirken). Der Steuerelektrodenbereich mit den veränderten Materialeigenschaften kann als eine Schicht verwendet werden, die die Steuerelektrode und das steuerbare Element voneinander trennt. Oder das Material kann aus diesem Bereich entfernt werden (z.B. nach dem Verfahren der selektiven Ätzung). Wird das Material entfernt, so kann die Breite des resultierenden Abstands vergrößert werden, wenn das steuerbare Element fähig ist, infolge der elastischen Verformung in mechanischen Kontakt mit der Steuerelektrode zu treten und somit die Möglichkeit der Wiederholung der lokalen Eigenschaftsänderung der Steuerelektrode sicherzustellen. Dieser Vorgang kann solange wiederholt werden, bis die Abstandsbreite die Fähigkeit des steuerbaren Elements zur elastischen Verformung überschreitet.

Eine interessante Möglichkeit bietet sich an, wenn als Material der Steuerelektrode ein chemisch inertes Material (z.B. Gold) und als steuerbares Element ein mehrschichtiges Kohlenstoffnanoröhrchen eingesetzt wird. In diesem Fall regt die entsprechend angelegte Verschiebungsspannung zwischen der Steuerelektrode und dem Kohlenstoffnanoröhrchen die anodische Oxidation von wenigstens einer Außenschicht des Nanoröhrchens an. Die Mindestgröße des auf diese Weise hergestellten Abstands, welcher das Nanoröhrchen von der Goldelektrode abtrennt, wird dem Zwischenschichtabstand im Kohlenstoffnanoröhrchen entsprechen. Dieser Zwischenschichtabstand beträgt ca. 0,33 nm. Diese Größe kann als Grenzwert des Auflösevermögens des in der Erfindung vorgeschlagenen Verfahrens der Selbstjustierung der Steuerelektrode betrachtet werden.

Im allgemeinen Fall kann anstelle des mehrschichtigen Kohlenstoffnanoröhrchens ein anderer Gegenstand eingesetzt werden. Wenigstens ein Teil dieses Gegenstands wird aus einem Material ausgebildet, welches irreversible physikalische oder chemische Umwandlungen bei bestimmter physikalischer oder chemischer Einwirkung ausführt. Dabei wird diese Einwirkung mit Hilfe der Ausgangselektrode ausgeübt.

Die Translation der Geometrie des Kohlenstoffnanoröhrchens auf die Steuerelektrode unter Sicherstellung ihrer räumlichen Trennung mittels des minimalen Abstands kann mit Hilfe von z.B. zwei Verfahren erreicht werden: entweder nach dem beschriebenen Verfahren der lokalen Eigenschaftsänderung des Materials der Steuerelektrode unter dem Einfluss des Nanoröhrchens oder mittels Vorbeschichtung des Nanoröhrchens mit einer konformen Schicht des speziellen Materials. Dieses spezielle Material wird danach mit dem Material der Steuerelektrode beschichtet. Die Ausbildung des Abstands zwischen dem Nanoröhrchen und der Steuerelektrode wird durch die nachfolgende selektive Entfernung dieser Schicht sichergestellt. Diese Schicht hat somit die Funktion der so genannten aufopfernden Schicht. Die Anforderungen an das Material der aufopfernden Schicht werden in diesem Fall sowohl durch die Möglichkeit ihrer selektiven Entfernung festgelegt, als auch durch die Fähigkeit, das Kohlenstoffnanoröhrchen konform zu bedecken. Aus dieser Sicht sieht die Beschichtung des Nanoröhrchens mit einer molekularen Monoschicht sehr aussichtsreich aus. Die molekulare Monoschicht wird infolge des Selbstorganisationsvorgangs ausgebildet. Der Hauptfaktor, welcher die Selbstanordnung der Moleküle auf der Oberfläche eines Objekts festlegt, ist die so genannte Diphilie der Moleküle. Die Diphilie nimmt an, dass die Eigenschaften von einem Ende des Moleküls sich von den Eigenschaften ihres anderen Endes unterscheiden. Dabei ist dieser Unterschied von solcher Natur, dass die Sorption des Moleküls auf der Oberfläche des Gegenstands nur mit einem Molekülende energisch vorteilhaft und mit dem anderen Ende nicht vorteilhaft ist [Zhou C., Deshpande M. R., Reedb M. A. Applied physics letters. 1997. Vol. 71, No. 5, P. 611-613]. Als Ergebnis wird eine geordnete, ein Molekül starke Schicht auf der Oberfläche gebildet. Diese Schicht ist durch eine hohe strukturelle Vollkommenheit gekennzeichnet. Im allgemeinen Fall kann der beschriebene Mechanismus die Ausbildung einer kontrollierbaren Anzahl von Molekularschichten auf der Oberfläche sicherstellen.

Gemäß einer der Ausführungsformen der vorgeschlagenen Erfindung ist das Kohlenstoffnanoröhrchen von der Steuerelektrode durch einen Abstand getrennt. Dieser Abstand wird nach einem der oben beschriebenen Verfahren erreicht. Somit kann das Kohlenstoffnanoröhrchen mechanische Bewegungen frei ausführen. Das Nanoröhrchen ist elektrisch mit der Eingangselektrode gekoppelt. Die Steuerelektrode fungiert als Ausgangselektrode. Das Anlegen der Verschiebungsspannung zwischen der Eingangs- und der Ausgangselektrode ermöglicht es, das Nanoröhrchen mittels der Coulombkraft zu beeinflussen. Bei bestimmter angelegter Verschiebungsspannung stellt die elastische Verformung des Nanoröhrchens den Übergang des Nanoröhrchens in den Zustand des mechanischen und folglich des elektrischen Kontakts mit der Oberfläche der Ausgangselektrode sicher. In diesem Zustand sorgt das Nanoröhrchen für den Elektrodentransport zwischen der Eingangs- und der Ausgangselektrode. Das können Strom- oder Spannungsmessmittel erfassen, die im Signalverkehr mit der Ein- oder der Ausgangselektrode stehen.

Da der mechanische Kontakt des Nanoröhrchens mit der Ausgangselektrode die elastische Verformung des Nanoröhrchens voraussetzt (dank dieser Verformung überwindet das Nanoröhrchen den Abstand, welcher es von der Ausgangselektrode abtrennt), entstehen Federkräfte, die danach streben, diesen Kontakt zu unterbrechen und das Nanoröhrchen in den unverformten Ausgangszustand zurückzubringen. Diesen Kräften wirken die Van-der-Waalsschen Kräfte entgegen. Die Van-der-Waalsschen Kräfte entstehen unmittelbar im Bereich des mechanischen Kontakts. Je nach diesem Kräfteverhältnis wird der mechanische Kontakt zwischen dem Nanoröhrchen und der Steuerelektrode entweder erhalten bleiben (stabiler Kontakt) oder unterbrochen sein (kurzfristiger Kontakt).

Der Charakter des mechanischen Kontakts kann mit Hilfe von folgenden Verfahren vorgegeben werden. Erstens legt die Abstandsgröße zwischen dem Nanoröhrchen und der Ausgangselektrode die Verformung fest. Das Nanoröhrchen muss dieser Verformung ausgesetzt werden, um den Kontakt mit der Ausgangselektrode herzustellen. Folglich legt die Abstandsgröße zwischen dem Nanoröhrchen und der Ausgangselektrode auch die Größe der Federkraft fest, welche danach strebt, das Nanoröhrchen in den Ausgangszustand zu bringen. Zweitens bestimmen die Oberflächeneigenschaften des Nanoröhrchens und der Ausgangselektrode die Größe der im Kontaktbereich wirkenden Van-der-Waalsschen Kräfte. Somit können diese Eigenschaften z.B. mittels Funktionalisierens der Oberfläche oder mittels ihrer bestimmten Beschichtung vorgegeben werden. Drittens kann die Coulomb-Wechselwirkung des Nanoröhrchen und der Ausgangselektrode verwendet werden. Die Coulomb-Wechselwirkung kann sowohl abstoßend als auch anziehend sein. Im ersten Fall werden das Nanoröhrchen und die Ausgangselektrode mit der gleichnamigen elektrischen Ladung geladen. Im zweiten Fall besteht zwischen dem Nanoröhrchen und der Ausgangselektrode die Potentialdifferenz und fließt elektrischer Strom. Die Coulomb-Kraft wirkt auf das Nanoröhrchen ein, welches im mechanischen Kontakt mit der Ausgangselektrode steht. Um die effektivere Kontrolle der Coulomb-Kraft zu erreichen, kann eine zusätzliche Elektrode angewendet werden, die in keinem direkten elektrischen Kontakt mit dem Nanoröhrchen ist.

Gemäß einer der Ausführungsformen der vorgeschlagenen Erfindung kann das Kohlenstoffnanoröhrchen mechanische Schwingungen mit Eigenfrequenzen frei ausführen. Wenn die Verschiebungsspannung mit einer entsprechenden Spannung zwischen dem Nanoröhrchen und der Ausgangselektrode angelegt wird, wird die Erregung der Resonanzschwingungen des Kohlenstoffnanoröhrchens sichergestellt. Die Geometrie des Nanoröhrchens und die Abstandsbreite zwischen dem Nanoröhrchen und der Ausgangselektrode sind so vorgegeben, dass bei bestimmter Amplitude der angelegten Verschiebungsspannung die Amplitude der Resonanzschwingungen des Nanoröhrchens dafür ausreichend wird, dass das Nanoröhrchen in den Zustand des stabilen oder kurzfristigen mechanischen Kontakts mit der Ausgangselektrode übergeht. In diesem Zustand stellt das Nanoröhrchen den Elektronentransport zwischen der Eingangs- und der Ausgangselektrode sicher. Dies kann durch Strom- oder Spannungsmessmittel erfasst werden. Diese Messmittel stehen im Signalverkehr mit der Eingangs- oder der Ausgangselektrode. Das ist das einfache Verfahren zur Messung der Resonanzschwingungsfrequenz des Nanoröhrchens. Dieses Verfahren unterscheidet sich von den bekannten Verfahren. Die bekannten Verfahren beruhen z.B. auf der Messung der Modulation der elektrischen Kapazität des Systems Nanoröhrchen - räumlich abgetrennte Elektrode oder der Modulation des Widerstands oder der Dichte der Ladungsträger des Nanoröhrchens. Das oben beschriebene einfache Verfahren bedarf keiner Auswertung des elektrischen Hochfrequenzsignals. Das vereinfacht seine Ausführung und verringert die Anforderungen an die Störkapazitäten des Systems. Es sei bemerkt, dass die Genauigkeit der Bestimmung der Resonanzfrequenz nach diesem Verfahren im Falle der Ausführung von einigen Messiterationen erhöht werden kann. Das hängt mit der Rolle des Verschiebungsspannungswertes der erregenden Schwingung des Nanoröhrchens zusammen. Wenn die erregende Spannung den Mindestwert überschreitet, welcher für den Übergang des Nanoröhrchens zum Kontakt mit der Ausgangselektrode erforderlich ist, kann dieser Übergang bei beliebiger Frequenz der erregenden Spannung zustande kommen, wenn diese Frequenz innerhalb der gewissen Umgebung der Resonanzfrequenz liegt. (Je größer die Dimensionen dieser Umgebung, desto mehr überschreitet die Verschiebungsspannung den Mindestwert). Da der Mindestwert der erregenden Verschiebungsspannung in der Praxis unbekannt sein kann, ist es nach der ersten Iteration der Resonanzfrequenzmessung zweckmäßig, die erregende Spannung herabzusetzen und den Messvorgang zu wiederholen. Um die Anzahl der erforderlichen Iterationsschritte zu vermindern, können unterschiedliche numerische Rechenmethoden angewendet werden. Es handelt sich insbesondere um das Verfahren der Dichotomie oder der Zweiteilung der Strecke. Dank der äußerst hohen Güte des Nanoröhrchens in der Funktion des Oszillators [US2002167375] (das bedeutet die entsprechende Enge der Resonanzspitze) kann eine ziemlich hohe Messgenauigkeit der Resonanzfrequenz nach dem vorgeschlagenen Verfahren erwartet werden.

Gemäß einer der Ausführungsformen der vorgeschlagenen Erfindung wird ein energieunabhängiger Speicher vorgesehen. Der energieunabhängige Speicher wird durch die Möglichkeit des Erreichens der hohen Integrationsstufe und das Vorhandensein der zusätzlichen unabhängigen Adressierungskoordinate gekennzeichnet. Als Adressierungskoordinate wirkt dabei die Resonanzfrequenz des adressierbaren Elements. Dafür wird die Menge der Kohlenstoffnanoröhrchen in den Gruppen gesammelt. Dabei weisen die Kohlenstoffnanoröhrchen in jeder Gruppe gemeinsame Eingangs- und Ausgangselektroden auf. Diese Elektroden werden nach den Verfahren der traditionellen Lithografie gebildet. Die räumliche Trennung der Kohlenstoffnanoröhrchen jeder Gruppe von der ihnen entsprechenden Ausgangselektrode wird nach einem der oben beschriebenen Verfahren der Selbstjustierung erreicht. Die Geometrie der Nanoröhrchen und die Breite der Abstände, die die Nanoröhrchen von den Ausgangselektroden trennen, sind so vorgegeben, dass im Falle des Übergangs des Nanoröhrchens zum mechanischen Kontakt mit der Ausgangselektrode dieser mechanische Kontakt stabil ist. Somit hat jedes Nanoröhrchen zwei stabile Zustände: der freie Zustand und der Zustand des mechanischen Kontakts mit der jeweiligen Ausgangselektrode. Beim vorliegenden mechanischen Kontakt kann das Nanoröhrchen den Elektronentransport zwischen der entsprechenden Eingangselektrode und der Ausgangselektrode ausführen. Das kann mit Hilfe von Mitteln zur Messung des elektrischen Stroms oder der Spannung erfasst werden. Diese Mittel stehen im Signalverkehr mit der Eingangs- oder der Ausgangselektrode. Damit das gewisse Nanoröhrchen aus dem freien Zustand in den Zustand des mechanischen Kontakts wechselt, muss die Verschiebungsspannung zwischen der Eingangs- und der Ausgangselektrode jener Nanoröhrchengruppe, der das betroffene Nanoröhrchen angehört, angelegt werden, so dass die Verschiebungsspannungsfrequenz der Resonanzfrequenz dieses Nanoröhrchens entspricht. Weisen die übrigen Nanoröhrchen in dieser Gruppe Resonanzfrequenzen auf, die von der Resonanzfrequenz des adressierbaren Nanoröhrchens abweichen, wird ihre mechanische Bewegung kein Resonanzverhalten haben. Folglich wird die mechanische Bewegung durch eine geringe Schwingungsamplitude gekennzeichnet sein. Das adressierbare Nanoröhrchen wird dagegen dank dem Resonanzeffekt eine große mechanische Schwingungsenergie aufspeichern. Das wird es dem adressierbaren Nanoröhrchen ermöglichen, insoweit verformt zu werden, dass es in der jeweiligen Schwingungsphase die Ausgangselektrode erreichen und zum stabilen Zustand des mechanischen Kontakts wechseln wird. Damit das Nanoröhrchen in den freien Ausgangszustand zurückkommt, muss das gleichnamige elektrische Potential an das Nanoröhrchen und die damit kontaktierende Ausgangselektrode oder die zusätzliche und vom Nanoröhrchen abisolierte (abgetrennte) Elektrode angelegt werden. Die Eingans- und die Ausgangselektrode sind für alle Nanoröhrchen der Gruppe gemeinsam. Deswegen wird diese Handlung im Endeffekt die Versetzung aller Nanoröhrchen der Gruppe in den stabilen freien Zustand bewirken. D.h., in diesem Betriebszustand wird ein energieunabhängiger Speicher erzielt, welcher einen freien Aufnahmezugriff sicherstellt. Jedoch kann das Überschreiben nur mittels Rücksetzens des Zustands aller Nanoröhrchen der Gruppe ausgeführt werden. Diese Einschränkung kann überwunden werden, wenn das Nanoröhrchen, welches die Ausgangselektrode mechanisch berührt, auch freie mechanische Schwingungen mit Eigenfrequenzen ausführen kann. Die Resonanzfrequenz des kontaktierenden Nanoröhrchens wird die Resonanzfrequenz der jeweiligen Größenordnung der Resonanz desselben Nanoröhrchen im freien Zustand überschreiten. Das liegt daran, dass der Kontaktbereich als zusätzlicher Befestigungspunkt des Nanoröhrchens wirkt und die Gesamtfestigkeit der Nanoröhrchenstruktur somit erhöht sein wird. Als Beispiel gilt das Nanoröhrchen, welches senkrecht auf dem Träger befestigt wird. Rings herum ist die Ausgangselektrode koaxial angeordnet. Im freien Zustand hat das Nanoröhrchen einen Befestigungspunkt und kann wie ein fliegend befestigter Balken schwingen. Beim Kontakt mit der Ausgangselektrode wird das Nanoröhrchen an beiden Enden befestigt und kann wie eine Saite frei schwingen. Dabei steigt die Frequenz ihrer eigenen Schwingungen um mehr als das Zweifache.

Durch die Erregung der Resonanzschwingungen des Nanoröhrchens, welches mechanisch kontaktiert wird, kann dem Nanoröhrchen eine große Energie der mechanischen Bewegung vermittelt werden. Dabei wird in den bestimmten Schwingungsphasen die Federkraft infolge der Verformung des Nanoröhrchens entstehen. Diese Federkraft strebt danach, den mechanischen Kontakt zu unterbrechen. Dabei wird diese Kraft mit der abstoßenden Phase der Coulomb-Kraft synchronisiert sein. Die Coulomb-Kraft wirkt von der Seite der Ausgangselektrode. Als Ergebnis wird der Bruch des mechanischen Kontakts des mitschwingenden Kohlenstoffnanoröhrchens bei geringeren Verschiebungsspannungen als bei anderen Nanoröhrchen erfolgen. Somit wird die Möglichkeit der Anregung des Wechsels des bestimmten Nanoröhrchens vom Zustand des mechanischen Kontakts mit der Ausgangselektrode zum freien Zustand bewerkstelligt.

Um den Zustand eines einzelnen Nanoröhrchens ablesen zu können, kann auch der Resonanzeffekt angewendet werden. Dafür geht das Untersystem, welches das betreffende (abzulesende) Nanoröhrchen (d.h. eine Speicherzelle) enthält, in den Betrieb zur Filterung des elektrischen Signals über. (Dieses Verfahren der Anwendung der Strukturen auf der Basis von Kohlenstoffnanoröhrchen ist in Patentschriften [WO02080360, US2002167375, EP1646145, W02007030423] beschrieben). Das Wesen des Betriebs eines solchen Filters besteht darin, dass die mechanischen Resonanzschwingungen des Nanoröhrchens für die Modulation des elektrischen Ausgangsignals sorgen. Dabei entspricht die Frequenz einer solchen Modulation der Resonanzfrequenz des Nanoröhrchens. Das Eingangssignal spielt dabei die Rolle des Schwingungserregungssignals des Nanoröhrchens. Als Ergebnis wird aus diesem Eingangssignal nur jene Harmonische ausgesondert, deren Frequenz der Resonanzfrequenz des Nanoröhrchens entspricht. Alle übrigen Harmonischen werden zurückgehalten (abgefiltert). Der physikalische Mechanismus, welcher für die Umsetzung der mechanischen Bewegung des Nanoröhrchens in die Modulation des elektrischen Ausgangssignals zuständig ist, kann unterschiedlich sein. Da die beschriebene Struktur zwei stabile Zustände hat, sind zwei Betriebsarten dieser Struktur als Filter für elektrische Signale möglich. Im freien Zustand des Nanoröhrchens wird die entsprechende Harmonische des an die Eingangselektrode gelieferten Signals an die Ausgangselektrode mittels Kapazitätskopplung gesendet. Die Stärke des Eingangssignals muss klein genug sein, damit das schwingende Nanoröhrchen die Ausgangselektrode auf keine Weise kontaktiert. Denn es handelt sich um einen Ablesevorgang, in dem der Zustand des Nanoröhrchens unverändert bleiben sollte.

Der nächste Stand der Technik gegenüber der Nanoröhrchenstruktur in dieser Betriebsart ist eine Einrichtung, die in Patentschriften [US2002167375 und EP1646145] offenbart ist. Beim mechanischen Kontakt des Nanoröhrchens wird ein Eingangssignal an die zusätzliche Elektrode angelegt. Die zusätzliche Elektrode ist vom Nanoröhrchen elektrisch getrennt. Die entsprechende Harmonische des Eingangssignals wird in den Stromkreis Eingangselektrode - Nanoröhrchen - Ausgangselektrode übertragen. Die Übertragung erfolgt mittels der Modulation des Widerstands oder der Ladungsträgerdichte des Nanoröhrchens. Hier ist diese Modulation die Folge einer mechanischen Verformung des Nanoröhrchens.

Der nächste Stand der Technik gegenüber der Nanoröhrchenstruktur bei dieser Betriebsart sind die Einrichtungen, die in den Patentschriften [WO02080360 und W02007030423] beschrieben sind. Somit kann der Zustand der einzelnen Nanoröhrchen in einer gegebenen Gruppe festgestellt werden, indem verschiedene Harmonische an die jeweiligen Elektroden der Nanoröhrchen-Gruppe geleitet und die Harmonischen ausgewertet werden, die sich ins Ausgangssignal durchgesetzt haben. Es sei bemerkt, dass sowohl der Ableseablauf als auch die oben beschriebenen Aufnahme- und Überschreibungsabläufe gleichzeitig für verschiedene Nanoröhrchen der Gruppe vorgenommen werden können. Das wird dadurch erreicht, dass die zum Ablesen oder zur Aufnahme gegebenen Signale die Überlagerung von unterschiedlichen Harmonischen darstellen. Jede dieser Harmonischen ruft eine Resonanzbewegung des entsprechenden Nanoröhrchens hervor.

Die oben beschriebene Ausführungsform der Erfindung als nichtflüchtiger Speicher stellt folgende Vorteile sicher:

- Die Integrationsstufe wird dank der Nutzung der Selbstorganisations- und Selbstjustierungseffekte durch die Möglichkeiten der traditionellen Lithografie nicht begrenzt. Die obere Grenze der Integrationsstufe entspricht der Nutzung von senkrechten einschichtigen Kohlenstoffnanoröhrchen als steuerbare Elemente und erreicht $10^{16}$ m$^{-2}$ und mehr.

- Dem Datenaufnahmemechanismus liegt die Vorgabe von einem der beiden stabilen mechanischen Zustände des Systems auf der Basis von Kohlenstoffnanoröhrchen zugrunde. Das stellt eine energieunabhängige Datenspeicherung sicher. Die mechanischen Zustände können auch eine größere Stabilität (von der Zeit her) aufweisen als die Ladungszustände, weil die letzteren für Verlusteffekte anfällig sind. Das ist auf der Nanoebene besonders wichtig. Außerdem stellt die Kombination des mechanischen Aufnahmeprinzips und der hohen Festigkeit der interatomaren Verbindungen im Kohlenstoffnanoröhrchen die Voraussetzungen für eine super hohe Bestrahlungsbeständigkeit dieses Speichers sicher.

- Die Dichte der erforderlichen Verbindungswege wird vermindert. Das ermöglicht es, einen der Engpässe des Prozesses der weiteren Miniaturisierung der Schaltelektronik zu überwinden. Alle Nanoröhrchen, die eine Gruppe bilden, haben gemeinsame Elektroden. Die Adressierung der Nanoröhrchen in der Gruppe erfolgt durch die Nutzung ihrer Resonanzfrequenzen. Somit kann die Anzahl der Verbindungswege um das N-fache vermindert werden. Dabei ist N die Anzahl der Nanoröhrchen, die in einer Gruppe zusammengesetzt sind. Der größte N-Wert wird durch die Weite des Resonanzfrequenzbereichs der Nanoröhrchen der Gruppe sowie durch die Mindestdifferenz der Resonanzfrequenzen von zwei Nanoröhrchen festgelegt, die es noch ermöglicht, diese Nanoröhrchen einzeln zu adressieren. Da der Oszillator in Form eines Kohlenstoffnanoröhrchens eine Rekordgüte (bis zu $10^5$ im Vakuum [US2002167375]) aufweist und durch eine enge Resonanzspitze gekennzeichnet ist, wird das Auflösungsvermögen in Bezug auf die Resonanzfrequenz mindestens einige Dutzende oder Hunderte Hertz betragen. Da die Schwingungsfrequenzen der Nanoröhrchen je nach ihrer Geometrie einige THz erreichen [Tsu-Wei Chou, Zhifeng Ren, Rod Ruoff, Hai Wang. NSF Nanoscale Science and Engineering Grantees Conference. 2003], beträgt die obere Grenze der Menge der nach der Resonanzfrequenz erkennbaren Zustände ca. $10^{9..11}$. Eine solch große Menge der erkennbaren Zustände zeugt davon, dass die Resonanzfrequenz einen äußerst umfangreichen Adressierungskennwert darstellt. Somit können die Anforderungen an das Auflösevermögen der Fotolithografie zur Herstellung von Elektroden wenigstens um einige Größenordnungen herabgesetzt werden. Dabei wird die Integrationsstufe maximal erhalten bleiben. Um die kontrollierbare Differenzierung der Nanoröhrchen in der Gruppe je nach Resonanzfrequenzen zu erreichen, kann während des Züchtens der Nanoröhrchen der Gradient der Wachstumsbedingungen in Bezug auf die Gruppe (z.B. Konzentrationsgradient des Dampf-Gas-Gemisches, der Temperatur, der Dimensionen von Katalysatorteilchen usw.) oder der Gradient der Behandlungsbedingungen der gezüchteten Nanoröhrchen (Gradient der Ätzungsintensität der Nanoröhrchen, der Beschichtungsintensität der Nanoröhrchen mit zusätzlichem Material usw.) sichergestellt werden.

Die Schnellwirkung des beschriebenen Speichers muss auch eingehend betrachtet werden. Infolge des Resonanzprinzips der Funktion des Arbeitsspeichers muss für jede Aufnahme- oder Ableseoperation die Zeit verbraucht werden, die einigen Perioden der Resonanzschwingungen gleich ist. (Das Nanoröhrchen speichert die Energie der mechanischen Bewegung allmählich während der Schwingungen auf). Die Schwingungsfrequenz des Kohlenstoffnanoröhrchens kann einige THz erreichen. Mit Hinblick darauf liegt die obere Frequenzgrenze beim Betrieb des vorgeschlagenen Speichers innerhalb von Dutzenden und Hunderten GHz.

Gemäß einer der Ausführungsformen der vorgeschlagenen Erfindung ist ein selektiver hochempfindlicher Gassensor vorgesehen. Während das Nanoröhrchen die Moleküle irgend eines Gases adsorbiert (Im allgemeinen Fall kann auch die Gasadsorption erfolgen, weil die Nanoröhrchenoberfläche eine Schicht von quasi flüssigem Adsorbat enthalten kann, welches in diesem Fall als Absorbens wirkt), werden die eigenen Schwingungsfrequenzen des Nanoröhrchens verlagert. Das wird durch die Wirkung von folgenden Mechanismen bedingt. Der erste Mechanismus beruht auf einem so genannten gravimetrischen Effekt. Er besteht in der Änderung der Frequenz der Eigenschwingungen bei der Änderung der Liniendichte des Nanoröhrchens infolge der Gewichtsänderung des Gasadsorbats auf seiner Oberfläche. Die Resonanzfrequenz erster Ordnung des fliegend befestigten Nanoröhrchens wird durch die folgende Formel vorgegeben [US2002167375]:

$$f \approx \frac{(1{,}875)^2}{8\pi} \frac{1}{L^2} \sqrt{D^2 + D_i^2} \sqrt{\frac{E_b}{\rho}} \qquad (1)$$

Hier sind
L - Länge,
D und $D_i$ - Außen- und Innendurchmesser,
$E_b$ - Youngscher Modul (E-Modul), und
$\rho$ - Dichte (1,33 g/cm$^3$).

Für das Nanoröhrchen mit einer Länge von 100 nm und Durchmessern von 10 und 8 nm sagt diese Formel eine Resonanzfrequenz von ca. 4 GHz voraus. Die effektive Dichte des Nanoröhrchens wird mit der Zunahme der Masse des adsorbierbaren Gases zunehmen, und die Frequenz wird indirekt proportional mit der Quadratwurzel aus dieser Dichte abfallen.

Der zweite Mechanismus beruht auf dem Änderungseffekt der mechanischen Spannungen im Nanoröhrchen infolge der Zusammenwirkung der aktiven Mittelpunkte der Nanoröhrchenoberfläche mit den Molekülen des adsorbierbaren Gases. Dieser Vorgang verursacht eine Härteveränderung des Nanoröhrchens und den jeweiligen Wandel des effektiven E-Modul-Wertes in der Formel (1). Das Härteänderungsverhalten des Nanoröhrchens wird durch die Eigenschaften seiner Oberfläche und den Typ des adsorbierbaren Gases festgelegt. So ist zum Beispiel für das Kohlenstoffnanoröhrchen bekannt, dass bei einer Beanspruchung mit $CO_2$-Gas die mittlere Länge der Verbindungen zwischen den Kohlenstoffatomen im Nanoröhrchen infolge der Sorption der Kohlendioxidmoleküle vergrößert wird [Zribi A., Knobloch A., Rao R. Applied Physics Letters. 2005. Vol. 86. Issue 20]. Im Falle eines fliegend befestigten Nanoröhrchens entspricht dies der Minderung seiner Härte und dem jeweiligen Abgang der Frequenz von den Eigenschwingungen.

Im allgemeinen Fall kann die Adsorption der Moleküle durch die Nanoröhrchen nicht nur aus der Gas- sondern auch aus der flüssigen Phase erfolgen. Das flüssige Medium leistet der Bewegung des Nanoröhrchens Widerstand. Deswegen wird die Güte des Nanoröhrchen-Oszillators in der Flüssigkeit niedriger sein. Jedoch kann der Nanoröhrchen-Oszillator dank einer hohen Ausgangsgüte seine Funktionsfähigkeit beibehalten (dabei ist der Rückgang des Auflösevermögens nach der Resonanzfrequenz unvermeidlich). Somit kann die in der Erfindung vorgeschlagene Funktionsstruktur eine Anwendung bei der Analyse der Zusammensetzungen von flüssigen Medien finden.

Wenn bekannt ist, welches in der Atmosphäre vorhandene Gas die Änderung der Resonanzschwingungsfrequenz des Nanoröhrchens verursacht, so kann an der Größe dieser Änderung die Konzentration dieses Gases ermittelt werden. Die hohe Empfindlichkeit dieses Verfahrens ist durch einige Faktoren bedingt. Erstens ist dies einmal die hohe spezifische Oberfläche des Kohlenstoffnanoröhrchens. Das führt zu einer Empfindlichkeitserhöhung der Resonanzfrequenz des Nanoröhrchen-Oszillators gegenüber der Konzentration des erkennbaren Gases. Zweitens ist das die hohe Güte des Nanoröhrchen-Oszillators. Das führt zur Erhöhung der Ermittlungsgenauigkeit der Resonanzfrequenz und zur entsprechenden Vergrößerung des Auflösevermögens der Messung.

Weiter ist ein Beispiel für die Schilderung des Potentials des Nanoröhrchen-Oszillators in der Funktion eines Gassensors angeführt. Es gab Versuche, bei denen ein Siliziumbalken anstelle des Nanoröhrchens als Resonator eingesetzt wurde. Die Oberfläche des Siliziumbalkens wurde mit einem Netz aus Kohlenstoffnanoröhrchen belegt. Dabei wurde die Abhängigkeit der Resonanzschwingungsfrequenz dieses Resonators von der Konzentration der $H_2O$- und der $CO_2$-Moleküle in der Atmosphäre festgestellt. Insbesondere wurde für $H_2O$ ein Auflösungsvermögen von ca. 3 ppm (oder $3 \times 10^6$ at %) erreicht. Die spezifische Oberfläche des genutzten Siliziumbalkens und seine Güte sind jeweils um 3-4 und 1-3 Größenordnungen kleiner als die spezifische Oberfläche und die Güte des Nanoröhrchen-Oszillators. Das Messauflösungsvermögen steigt proportional sowohl mit der Vergrößerung der spezifischen Oberfläche als auch mit der Güteerhöhung an. Mit Rücksicht darauf kann das Auflösungsvermögen für den Nanoröhrchen-Oszillator als Gassensor in der Höhe von $10^{-8}$-$10^{-11}$ at % (d.h. 1 Molekül des zu erkennenden Gases pro $10^{10}$ - $10^{13}$ Moleküle der Atmosphäre) extrapoliert werden.

Gemäß einer der Ausführungsformen der vorgeschlagenen Erfindung eines selektiven Gassensors wird der Mechanismus der zwangsläufigen Gasdesorption realisiert. Das ist erforderlich, um die Regenerationszeit des Aufnahmeelements des Sensors vor einer nachfolgenden unabhängigen Messung zu kontrollieren. Die zwangsläufige Desorption wird nach dem so genannten Verfahren der thermischen Entflammung ausgeführt. Dabei wird das Nanoröhrchen bis zu einer Temperatur erwärmt, welche die Schwellentemperatur der Adsorption der Gasmoleküle dieser Art überschreitet. Dies erfolgt dadurch, dass der elektrische Strom mit einer hohen Dichte durch das Nanoröhrchen durchgelassen wird oder der Wärmeaustausch mit einer externen Wärmequelle (z.B. mit einem in der Nähe angeordneten Widerstanderhitzer) zustande kommt. Wird der elektrische Strom durch das eigentliche Nanoröhrchen geleitet, so kann die Desorption nicht nur durch die thermische Aktivierung der adsorbierten Moleküle sondern auch durch den Stromaktivierungsmechanismus erfolgen. Um den elektrischen Strom durch das Nanoröhrchen durchzulassen, werden entweder zwei oder nur eine Elektrode (z.B. Eingangselektrode) benutzt, die im Dauerkontakt mit dem Nanoröhrchen sind. Im zweiten Fall spielt die zweite Elektrode die Rolle der Ausgangselektrode und bildet mit dem Nanoröhrchen einen lösbaren Kontakt aus. Wird der Effekt der Feld- oder der thermischen Elektronemission des Nanoröhrchens angewendet [Bonard J.M., Kind H., Stockli T., et al. Solid-state electronics. 2001. Journal SSE. Article No. 2586. P. 1-22], so kann der elektrische Strom durch das Nanoröhrchen mit Hilfe von nur einer damit kontaktierenden Elektrode geleitet werden.

Die Desorption kann auch mittels einer Beanspruchung des Nanoröhrchens mit elektromagnetischer Strahlung mit entsprechender Wellenlänge (z.B. Strahlung im UV-Bereich) erreicht werden.

Gemäß einer der Ausführungsformen der vorgeschlagenen Erfindung eines selektiven Gassensors sind alle oder einige der folgenden Selektivitätsvorgänge implementiert, die es ermöglichen, die Gase nach drei Typen zu unterscheiden.

- Die Oberfläche des Kohlenstoffnanoröhrchens kann funktionalisiert sein. Das heißt, diese Oberfläche kann auf eine bestimmte Weise chemisch behandelt werden. Als Ergebnis gewinnt das Element an der Fähigkeit, mit Gas einer bestimmten Art selektiv zusammenzuwirken. Somit werden der Oberfläche des Nanoröhrchens gewisse Eigenschaften verliehen. Dies kann sowohl während des Züchtens des Nanoröhrchens als auch bei der nachfolgenden Behandlung erfolgen. Es ist offensichtlich, dass die Anwendbarkeit und die Effektivität dieses Selektivitätsmechanismus durch die Verfügbarkeit und die Effektivität der entsprechenden chemischen (oder biologischen) Reagenzien festgelegt werden. Die Moleküle dieser Reagenzien können sich einerseits an die Oberfläche eines festen Körpers chemisch oder physikalisch haften (d.h., die Oberfläche kann durch diese Moleküle "funktionalisiert" werden). Andererseits können sie selektiv und unumkehrbar mit den Gasen bzw. den Teilchen der benötigten Arten zusammenwirken.

- Der zweite Selektivitätsmechanismus beruht darauf, dass die Verschiebung der Resonanzfrequenz von den Kennwerten des Nanoröhrchens wie Länge, Durchmesser und Struktur abhängt. Und zwar ist diese Abhängigkeit für jede Gasart einmalig. Infolge der Adsorption werden der gravimetrische Effekt und der Effekt der Veränderung der mechanischen Spannungen beobachtet. Diese Effekte werden verschiedene Verhältnisse für verschiedene Gasarten aufweisen. Das liegt daran, dass ihre Moleküle verschiedene Massen, verschiedene Mechanismen und verschiedene Energie der Verbindungen mit den aktiven Mittelpunkten der Nanoröhrchenoberfläche aufweisen. Die gravimetrische Komponente der Resonanzfrequenzverschiebung hat ihre eigene Abhängigkeit von der Länge/ Durchmesser/ Struktur des Nanoröhrchens. Diese Abhängigkeit stimmt mit der Abhängigkeit der Verschiebungskomponente der durch die mechanischen Spannungen bedingten Resonanzfrequenz von diesen Kennwerten nicht überein. Dabei ist die Abhängigkeit der "mechanischen" Komponente im allgemeinen Fall für verschiedene Gasarten auch unterschiedlich. Im Endeffekt kann nach den Verhältnissen zwischen den Verschiebungswerten der Resonanzfrequenz, die den Nanoröhrchen mit wesentlich abweichenden Längen/Durchmessern/Strukturen entsprechen, über die jeweilige Gasart geurteilt werden. Danach wird eine korrekte Auslegung der absoluten Verschiebungswerte der Resonanzfrequenz möglich, um die Konzentration von Gas bestimmter Art bestimmen zu können. Es liegt also die Aufgabe der Interpretation von relativen und absoluten Verschiebungen der Resonanzfrequenz für einen Sensor mit beliebig wählbarer Anzahl von Nanoröhrchen mit beliebigen Kenndaten vor. Diese Aufgabe lässt sich sehr einfach mit Hilfe einer Kalibrierung dieses Sensorstücks lösen. Die Kalibrierung wird für alle betreffenden Gasarten vorgenommen. Die Effektivität dieses Selektivitätsmechanismus steigt mit der Vergrößerung der Unterschiede der Eigenschaften der Nanoröhrchen, die in der Messung verwendet wurden. Wenn irgendeine Eigenschaft der Nanofaser einen zufälligen Charakter hat (z.B. Struktur und Anzahl der Fehler), ist es zweckmäßig, mehr Nanoröhrchen im Sensor zu gebrauchen und somit die Wahrscheinlichkeit zu erhöhen, dass dabei Nanoröhrchen entstehen, deren Merkmale der bestimmten Gasart umfassender und optimaler entsprechen. Die Abmessungen des Nanoröhrchens (mindestens ihre Querabmessungen) sind äußerst gering. Die Züchtungstechnologien der Nanoröhrchen erfüllen die Voraussetzung über den massigen Parallelismus. Deswegen kommt eine bauliche Vereinigung von vielen Nanoröhrchen in einer Einrichtung zweckdienlich vor. Neben den Unterschieden nach Länge, Durchmesser und Struktur können sich die Nanoröhrchen auch nach dem Vorhandensein einer Oberflächenfunktionalisierung und ihren Kennwerten unterscheiden.

- Der dritte Selektivitätsmechanismus beruht auf verschiedenen Temperaturabhängigkeiten der Adsorption bei verschiedenen Gasarten. Das bezieht sich insbesondere auf die Differenzen der Temperaturschwellen der Adsorption. Bei der Adsorption überschreitet die Bindungsenergie der Gasmoleküle mit aktiven Zentren der Oberfläche des festen Körpers nicht mehr die Energie der Wärmebewegung dieser Moleküle. Die Implementierung dieses Selektivitätsmechanismus ist möglich, indem die "Kalt und "Warmläufe" abgewechselt werden. Dabei variieren auf entsprechende Weise die Temperaturen von allen oder einzelnen oszillierenden Nanoröhrchen. Die Temperaturkontrolle von einzelnen Nanoröhrchen erfolgt je nach der Größe des durch diese Nanoröhrchen fließenden elektrischen Stroms oder durch die Intensität der Erhitzung oder Bestrahlung mit irgendwelcher externen Quelle. Die Information über die Art des adsorbierbaren Gases ergeben die Verhältnisse zwischen den Verschiebungswerten der Resonanzfrequenz. Diese Verschiebungswerte entsprechen verschiedenen Temperaturverhalten beim Betrieb. Um eine richtige Auslegung dieser Verhältnisse sicherzustellen, ist eine Vorkalibrierung für alle betreffenden bzw. interessanten Gasarten zu empfehlen. (Diese Vorkalibrierung empfiehlt sich auch für alle anderen unten genannten Selektivitätsmechanismen).

- Dem vierten Selektivitätsmechanismus liegt die Einmaligkeit der Elektroneneigenschaften der Moleküle verschiedener Typen zugrunde. Wenn das Nanoröhrchen in den Zustand des mechanischen Kontakts mit der Ausgangselektrode übergeht, so werden die Besonderheiten des Elektronentransports in dem auf diese Weise gebildeten Stromkreis die Information über die Elektroneneigenschaften der Moleküle mit sich tragen, die sich auf der Oberfläche des Nanoröhrchens im Kontaktbereich befinden. Dies wird sich in den Kennwerten des statischen und dynamischen Strom-Spannungs-Verhaltens der Struktur und in den Hysterese-Kennwerten dieser Verhalten zeigen.

- Der fünfte Selektivitätsmechanismus beruht auf einer unterschiedlichen Adhäsion des Nanoröhrchens zur Ausgangselektrode je nach den Eigenschaften des das Nanoröhrchen bedeckenden Adsorbats. Die Adhäsionsdifferenz bedingt Unterschiede im gleichnamigen elektrischen Potential, welches an das Nanoröhrchen und die damit kontaktierende Ausgangselektrode oder die zusätzliche vom Nanoröhrchen isolierte Elektrode angelegt werden muss, damit das Nanoröhrchen aus dem Zustand des mechanischen Kontakts in den freien Zustand wechselt.

- Der sechste Selektivitätsmechanismus beruht auf der Empfindlichkeit der Kennwerte der Feld- oder thermischen Elektronenemission des Nanoröhrchens je nach seinem Oberflächenzustand, insbesondere wenn die Oberfläche mit Adsorbat versehen ist. Wenn das Nanoröhrchen im freien Zustand ist, kann die Ausgangselektrode als Sammler der emittierten Elektronen dienen.

- Der siebente Selektivitätsmechanismus beruht auf den Differenzen des Widerstands, welchen das Medium der Nanoröhrchenbewegung je nach dem Typ der das Medium zusammenbildenden Gase leistet. Der gemäß dieser Erfindung erreichte Abstand zwischen dem Nanoröhrchen und der Ausgangselektrode kann sehr gering sein. Deswegen können die mechanischen Eigenschaften des den Abstand ausfüllenden Mediums die Frequenz der Resonanzschwingungen des Nanoröhrchens beachtlich beeinflussen.

- Der achte Selektivitätsmechanismus beruht auf der Anwendung von Beschichtungen aus Materialien, die eine selektive Durchlassfähigkeit aufweisen. Dieser Ansatz ist im Großen und Ganzen für Gasfühler beliebiger Art anwendbar. Er besteht im Wesentlichen darin, dass nur eine bestimmte Gasart in den Bereich des Aufnahmeelements des Gasfühlers durchgelassen wird. Alle anderen Bestandteile der Atmosphäre werden durch die selektive Beschichtung zurückgehalten. Die Anwendbarkeit und die Effektivität dieses Mechanismus werden durch den Entwicklungsstand der Technologien der selektiven Deckungen bestimmt.

Ein Teil der Nanoröhrchen kann baulich von der Gasbelichtung geschützt sein. Die Resonanzfrequenzverschiebungen dieser Nanoröhrchen sind durch die Veränderung ihrer Temperatur infolge der Umgebungstemperaturänderungen oder infolge der Strombeanspruchung bedingt. Sie können nur zum Ausgleich der Temperaturkomponente der Resonanzfrequenzänderungen jeder Nanoröhrchen eingesetzt werden, die vom Gas belichtet werden. Somit wird der vom Gas nicht belichtete (nicht beanspruchte) Teil der Nanoröhrchen im Grunde genommen die Funktion eines thermischen Sensors erfüllen.

Ausführungsbeispiel

Die katalytischen Nickelnanoteilchen werden auf der Oberfläche eines dielektrischen Trägers 1 (Fig. 6) mit Hilfe von Sol-Gel-Verfahren gebildet. Die Kohlenstoffnanoröhrchen werden im elektrischen Feld nach dem Verfahren der katalytischen Pyrolyse der Dämpfe des kohlenstoffhaltigen Gases (z.B. Butan-Propangemisches) gezüchtet. Als Ergebnis dieses Vorgangs wird eine Vielzahl von senkrecht ausgerichteten Kohlenstoffnanoröhrchen 2 hergestellt. Nach dem Verfahren der Laserablation oder Kathodenzerstäubung wird eine Metallschicht 3, z.B. eine Schicht von Tantal, aufgetragen. Diese Schicht hat die Funktion der Eingangselektrode. Diese Schicht sorgt auch für die zusätzliche Fixierung des Nanoröhrchens in der senkrechten Lage. Die dielektrische Schicht 4, z.B. eine Schicht von Aluminiumoxid, wird nach dem Verfahren der Magnetfeldauftragung hergestellt. Nach dem Verfahren der Kathodenzerstäubung wird die Schicht des amorphen Kohlenstoffs 5 aufgetragen. Diese Schicht hat die Funktion der Ausgangselektrode. Die Erhöhung der Leitfähigkeit der Schicht des amorphen Kohlenstoffs 5 wird nach dem Verfahren des thermischen Ausheilens erreicht. Zwischen der Eingangselektrode 3 und der Ausgangselektrode 5 wird eine Potentialdifferenz von mindestens 3 V angelegt und zwar so, dass die Ausgangselektrode 5 als Anode dient. Dabei kommt im Bereich rings um das Nanoröhrchen 2 eine Oxidation der Kohlenstoffschicht 5 zustande. Dabei wird das gasförmige $CO_2$ gebildet. Das führt zur Ausbildung eines Abstands zwischen dem Nanoröhrchen 2 und der Elektrode 5 (Fig. 7). Die Oxidation verläuft so lange, bis das Nanoröhrchen 2 von der Ausgangselektrode 5 völlig abgetrennt ist. Um die Oxidation zu ermöglichen, muss die Atmosphäre Sauerstoff oder Wasserdämpfe enthalten. Es besteht die Möglichkeit, den Abstand zwischen dem Nanoröhrchen 2 und der Ausgangselektrode 5 zu verbreitern. Dafür wird das Nanoröhrchen 2 mittels der Coulomb-Kraft in den Zustand des mechanischen Kontakts mit der Ausgangselektrode 5 (Fig. 2) gebracht. Danach wird die lokale anodische Oxidation der Ausgangselektrode 5 wiederholt. Diese Prozedur kann so oft wie erforderlich wiederholt werden. Damit keine unerwünschte Oxidation der Ausgangselektrode 5 beim Übergang des Nanoröhrchens 2 in den Zustand des mechanischen Kontakts während des Betriebs der hergestellten Struktur erfolgt, reicht es aus, entweder die erforderliche Polarität und den Bereich der Arbeitsverschiebungsspannung sicherzustellen oder die Oberfläche der Ausgangselektrode 5 mit einer zusätzlichen Schicht eines chemisch inerten, leitfähigen Materials 6 (Fig. 3) zu versehen.

Es sei auch das Problem der Wechselwirkung des Kohlenstoffnanoröhrchens mit den Teilchen der Substanz erwähnt, welche bei der Ausbildung der Leiterschicht 3 und der dielektrischen Schicht 4 aufgetragen wird. Im Idealfall müssen diese Teilchen Schichten 3 und 4 ausbilden und dabei die Oberfläche des Nanoröhrchens 2 frei von jeglichen Deckungen halten. Dafür müssen die auftragbaren Materialien und die Bedingungen für ihre Auftragung so gewählt werden, dass es für die Substanz von der Energie her nachteilig ist, auf der Oberfläche des Nanoröhrchens in Form von einem Vollüberzug oder sogar dispergiertem Überzug zu bleiben. Die Kohlenstoffnanoröhrchen mit Kleindurchmesser (einschichtige Nanoröhrchen oder Nanoröhrchen mit wenigen Schichten) haben einen kleinen Oberflächenabrundungshalbmesser und dementsprechend eine große Oberflächenenergie. Somit tragen sie zur Erfüllung dieser Bedingung bei. Die Kohlenstoffnanoröhrchen und die Nanofasern mit relativ großem Durchmesser (solche Strukturen können für manche Anwendungen gut geeignet sein, z.B. in der Sensortechnik) sind im Vergleich zu den aufgetragenen Dünnfilmen (5-10 nm) ziemlich massiv. Für diese Strukturen kann der Beitrag der an der Oberfläche vorhandenen dispersen Inseln der auftragbaren Materialien unbedeutend sein. Darüber hinaus kann das Wachstum der Masse des schwingenden Teils eine Güteerhöhung dieses Oszillators bedingen. Bei einer hohen Anisotropie der Auftragung, deren Richtung mit der Längsachse des Nanoröhrchens zusammenfällt, wird die Seitenoberfläche des Nanoröhrchens eine minimale Wechselwirkung mit den Teilchen der auftragbaren Substanz haben. Der überwiegende Vorgang wird dabei die Ausbildung eines Käppchen an der Nanoröhrchenspitze sein. Das wird noch mehr zur Erhöhung der Güte des Nanoröhrchen-Oszillators beitragen. (Dies wird durch den Abgang der Frequenz des Oszillators begleitet).

Alternativ kann die Gasphasen- oder Flüssigphasenepitaxie zur Ausbildung der Funktionsschichten der Struktur eingesetzt werden. Dies wird auf eine solche Weise realisiert, dass das Epitaxialwachstum des Films auf der Oberfläche des Trägers erfolgt, während die Oberfläche des Kohlenstoffnanoröhrchens keine Bedingungen für dieses Wachstum bietet.

Ähnlich kann auch eine Struktur mit einer zusätzlichern Ausgangselektrode 5 (Fig. 4) hergestellt werden. Dafür werden nach der Ausbildung des Abstands zwischen dem Nanoröhrchen 2 und der Ausgangselektrode 5 folgende zusätzliche Operationen ausgeführt: Auftragung einer zweiten dielektrischen Schicht 6, Auftragung einer zweiten Schicht des amorphen Kohlenstoffs 7 und eine lokale Oxidation der zweiten Schicht des amorphen Kohlenstoffs 7. Die hergestellte zusätzliche Elektrode (ihre Rolle spielt die erste Schicht des amorphen Kohlenstoffs 5) kann insbesondere zur Erregung der Schwingungen des Nanoröhrchens 2 verwendet werden. Das Nanoröhrchen ist dabei im Zustand des mechanischen Kontakts. Diese Betriebsart ist dann sinnvoll, wenn die Struktur als eine Zelle des oben beschriebenen nicht flüchtigen Speichers benutzt wird. Ihre Adressierung erfolgt, indem die Frequenz der angelegten Verschiebungsspannung vorgegeben wird. Die zusätzliche Elektrode 5 kann auch in Sensoranwendungen der Strukturen benutzt werden, z.B. zur Kontrolle der Resonanzschwingungsfrequenz oder zur Kontrolle des Verhältnisses der Kräfte, welche das Nanoröhrchen 2 an die Ausgangselektrode 7 anpressen, und der Kräfte, die danach streben, den mechanischen Kontakt des Nanoröhrchens 2 mit der Ausgangselektrode 7 zu unterbrechen.

Zur Ausbildung von Eingangs- und Ausgangselektroden kann die traditionelle Fotolithografie verwendet werden. Somit kann die Matrix der Elektroden 1 und 4 ausgebildet werden, die mittels einer dielektrischen Schicht 3 (Fig. 5) getrennt sind. Die Anzahl der Nanoröhrchen 2 mit gemeinsamen Elektroden 1 und 4 wird durch die Oberflächendichte der Nanoröhrchen 2 und die Breite der nach dem Fotolithografie-Verfahren ausgebildeten Elektroden 1 und 4 bestimmt. Um die Verteilungsgleichmäßigkeit der Nanoröhrchen 2 über die Oberfläche zu verbessern, kann als dielektrischer Träger 1 (Fig. 6) poröses Aluminiumoxid eingesetzt werden [Li J., Papadopoulos C., Xu J.M., et al. Applied physics letters. 1999. Vol. 75, Issue 3. P. 367-369]. In diesem Fall dringen die katalytischen Teilchen, die das Wachstum der Nanoröhrchen 2 sicherstellen, in die Oxidporen ein. Neben der Verbesserung der Verteilungsgleichmäßigkeit der Nanoröhrchen 2 wird sich auch ein Effekt der Ausrichtung des Wachstums der Nanoröhrchen 2 in Bezug auf ihre Porenwände zeigen. Als poröses Material kann Zeolith verwendet werden, dessen Poren mit 12-gliedrigen Ringen der Sauerstoffatome (Y-Zeolith) ausgebildet sind. Ihre typischen Dimensionen entsprechen dem Durchmesser der einschichtigen Kohlenstoffnanoröhrchen.

**Patentansprüche**

1. Nanoelektromechanische Struktur für verschiedene Anwendungen in der Sensortechnik und Mikrotechnik, **dadurch gekennzeichnet,** **dass** sie folgende Elemente einschließt:

   mindestens ein steuerbares, stromleitfähiges Element (2), wenigstens eine Eingangselektrode (3), die im elektrischen Kontakt mit dem steuerbaren Element (2) steht, und wenigstens eine Ausgangselektrode (5), die vom steuerbaren Element (2) getrennt und mit dem steuerbaren Element (2) elektrostatisch gekoppelt ist, wobei entweder mindestens ein Teil der Ausgangselektrode (5) aus einem Material ausgebildet ist, welches irreversible physikalische oder chemische Änderungen bei physikalischer oder chemischer und durch das steuerbare Element (2) vermittelter Einwirkung bewirkt oder mindestens ein Teil des steuerbaren Elements (2) aus einem Material ausgebildet ist, welches irreversible physikalische oder chemische Änderungen bei physikalischer oder chemischer und durch die Ausgangselektrode (5) vermittelter Einwirkung bewirkt.

2. Struktur nach Anspruch 1, **dadurch gekennzeichnet,** **dass** das steuerbare Element (2) als ein elastisches Element ausgebildet ist, welches seine Geometrie ändert.

3. Struktur nach Anspruch 2, **dadurch gekennzeichnet,** **dass** das elastische Element (2) mechanische Schwingungen mit Eigenfrequenzen frei ausführt.

4. Struktur nach Anspruch 2, **dadurch gekennzeichnet,**

**dass** sie zusätzlich Folgendes einschließt:

Mittel zur Erkennung eines elektrischen Signals, die im Signalverkehr mit wenigstens einer Ein- oder einer Ausgangselektrode (3 oder 5) stehen,
**dass** das elastische Element (2) in einen stabilen oder kurzzeitigen mechanischen Kontakt mit mindestens einer Ausgangselektrode (5) übergeht und
**dass** dabei die Mittel zur Erkennung des elektrischen Signals wenigstens die Erkennung von elektrischen Signaländerungen sicherstellen, die mit diesem stabilen oder kurzzeitigen mechanischen Kontakt zusammenhängen.

5. Struktur nach Anspruch 4,
**dadurch gekennzeichnet,**
**dass** mindestens ein Teil der Oberfläche von wenigstens einer Ausgangselektrode (5) mit einer Isolier- oder leitfähigen Schicht (6) versehen ist und dass diese Isolier- oder leitfähige Schicht (6) die Möglichkeit eines unmittelbaren mechanischen Kontakts zwischen dem elastischen Element (2) und dieser Ausgangselektrode (5) verhindert.

6. Struktur nach Anspruch 3,
**dadurch gekennzeichnet,**
**dass** sie zusätzlich Mittel zur Versorgung mit einer Verschiebungsgleichspannung zwischen dem elastischen Element (2) und der Ausgangselektrode (5) bzw. zwischen der Kombination der Ausgangselektroden aufweist,
**dass** diese Mittel eine Kontrolle der mechanischen Resonanzschwingungsfrequenz des elastischen Elements (2) oder im Falle des mechanischen Kontakts des elastischen Elements (2) mit wenigstens einer Ausgangselektrode (5) sicherstellen und
**dass** diese Mittel auch eine Kontrolle des Verhältnisses der Kräfte sicherstellen, die das steuerbare Element (2) an die Ausgangselektrode (5) anpressen, zu den Kräften, die den mechanischen Kontakt des steuerbaren Elements (2) mit der Ausgangselektrode (5) zu unterbrechen streben.

7. Struktur nach Anspruch 4,
**dadurch gekennzeichnet,**
**dass** die räumliche Trennung des elastischen Elements (2) und wenigstens einer Ausgangselektrode (5) oder die Oberflächeneigenschaften des elastischen Elements (2) und dieser Ausgangselektrode (5) oder die Verschiebungsspannung, welche zwischen dem elastischen Element (2) und der Ausgangselektrode (5) oder zwischen der Kombination der Ausgangselektroden angelegt ist, so vorgegeben sind, dass entweder ein stabiler oder ein kurzzeitiger mechanischer Kontakt des elastischen Elements (2) mit dieser Ausgangselektrode (5) sichergestellt ist.

8. Struktur nach Anspruch 2,
**dadurch gekennzeichnet,**
**dass** wenigstens ein Teil der Oberfläche des steuerbaren Elements (2) chemisch oder biologisch funktionalisiert ist.

9. Struktur nach Anspruch 3,
**dadurch gekennzeichnet,**
**dass** die elastischen Elemente (2) zu Gruppen von elastischen Elementen (2) vereinigt sind, dass die elastischen Elemente (2) in jeder Gruppe allgemeine Ein- und Ausgangselektroden (3 und 5) haben,
**dass** zusätzlich Mittel zur Adressierung der elastischen Elemente (2) oder Untergruppen von elastischen Elementen (2) eingeschlossen sind, wobei jedem elastischen Element (2) oder jeder Untergruppe von elastischen Elementen (2) in der Gruppe eine eigene Resonanzschwingungsfrequenz zugeordnet ist, dass Adressierungsmittel mittels Ein- und Ausgangselektroden (3 und 5) die Gruppe von elastischen Elementen (2) vorgeben, der das adressierbare elastische Element (2) oder die adressierbare Untergruppe von elastischen Elementen (2) angehören,
**dass** auf diese Weise auch die Frequenz der Verschiebungswechselspannung vorgegeben ist, die an die Kombination der Ein- und Ausgangselektroden (3 und 5) der vorgegebenen Gruppe von elastischen Elementen (2) anzulegen ist und dass diese Frequenz der Frequenz der Resonanzschwingungen des adressierbaren elastischen Elements (2) oder der Untergruppe von elastischen Elementen (2) entspricht.

10. Struktur nach Anspruch 9,
**dadurch gekennzeichnet,**
**dass** jedes elastische Element (2), wenn es im mechanischen Kontakt mit wenigstens einer Ausgangselektrode (5) steht, mechanische Schwingungen mit eigener Frequenz ausführt, dass diese Frequenz sich von der Eigenfrequenz dieses Elements unterscheidet, wenn kein mechanischer Kontakt vorliegt, dass die Adressierungsmittel die Frequenz der Verschiebungswechselspannung vorgeben, die an die Kombination der Ein- und Ausgangselektroden (1 und 4) der vorgegebenen Gruppe von elastischen Elementen (2) anzulegen ist und dass diese Frequenz der Resonanzschwingungsfrequenz des adressierbaren elastischen Elements (2) im Zustand des mechanischen Kontakts entspricht oder

**dass** diese Frequenz der Resonanzschwingungsfrequenz des adressierbaren elastischen Elements (2) bei fehlendem mechanischen Kontakt entspricht.

11. Struktur nach den Ansprüchen 9 oder 10,
   **dadurch gekennzeichnet,**
   **dass** die Adressierungsmittel die Verschiebungswechselspannung vorgeben, die an die Kombination der Ein- und Ausgangselektroden (1 und 4) der vorgegebenen Gruppe von elastischen Elementen (2) anzulegen ist,
   **dass** diese Verschiebungsspannung die Überlagerung der Wechselspannungen darstellt, deren Frequenzen unterschiedlich sind und
   **dass** die Frequenz jeder dieser Spannungen der Resonanzschwingungsfrequenz eines der elastischen Elemente (2) entspricht.

12. Struktur nach den Ansprüchen 1 oder 2,
   **dadurch gekennzeichnet,**
   **dass** das steuerbare Element (2) Kohlenstoff-Nanoröhrchen oder Kohlenstoffnanofasern oder ein Bündel von Kohlenstoffnanoröhrchen oder von Kohlenstoffnanofasern darstellt.

13. Struktur nach den Ansprüchen 1 oder 2,
   **dadurch gekennzeichnet,**
   **dass** mindestens ein Teil der Ausgangselektrode (5) aus einem Material auf Kohlenstoffbasis ausgebildet ist und
   **dass** dieses Material irreversible physikalische oder chemische Änderungen bei physikalischer oder chemischer Einwirkung durch das steuerbare Element (2) bewirkt.

14. Struktur nach den Ansprüchen 1 oder 2,
   **dadurch gekennzeichnet,**
   **dass** das steuerbare Element (2) ein mehrschichtiges Kohlenstoffnanoröhrchen darstellt und dass wenigstens eine Außenschicht des Nanoröhrchen mittels einer Einwirkung entfernt ist, die durch die Ausgangselektrode (5) vermittelt ist.

15. Struktur für verschiedene Anwendungen in der Sensortechnik und Mikroelektronik, die Folgendes aufweist:

   - wenigstens ein steuerbares Element (2), welches in Form eines elastischen, elektrisch leitfähigen und mechanisch mit Eigenfrequenz frei schwingbaren Elements ausgebildet ist;
   - wenigstens eine Eingangselektrode (3), die mit dem elastischen Element (2) in elektrischem Kontakt steht;
   - wenigstens eine Ausgangselektrode (5), die vom elastischen Element (2) räumlich getrennt und mit dem steuerbaren Element elektrostatisch gekoppelt ist;
   - Mittel zur Anlegung einer Verschiebungsspannung zwischen der Kombination der Ein- und Ausgangselektroden;
   - Mittel zur Erkennung eines elektrischen Signals, die im Signalverkehr mit wenigstens einer Ein- oder einer Ausgangselektrode stehen und dabei die Verschiebungsspannungsversorgungsmittel zur Erregung von mechanischen Schwingungen des elastischen Elements (2)sicherstellen, wobei die Amplitude der Resonanzschwingungen des elastischen Elements eine Größe hat, die den Übergang des elastischen Elements zum stabilen oder kurzen mechanischen Kontakt mit wenigstens einer Ausgangselektrode sicherstellt und
   - Mittel zur Erkennung eines elektrischen Signals, die wenigstens die Erkennung von Änderungen des elektrischen Signals sicherstellen, die mit diesem stabilen oder kurzen mechanischen Kontakt zusammenhängen.

16. Struktur nach Anspruch 15,
   **dadurch gekennzeichnet,**
   **dass** die elastischen Elemente zu Gruppen von elastischen Elementen vereinigt sind,
   **dass** die elastischen Elemente in jeder Gruppe allgemeine Ein- und Ausgangselektroden haben,
   **dass** zusätzlich Mittel zur Adressierung der elastischen Elemente oder Untergruppen von elastischen Elementen eingeschlossen sind,
   **dass** jedem elastischen Element oder jeder Untergruppe von elastischen Elementen in der Gruppe eine eigene Resonanzschwingungsfrequenz entspricht, dass Adressierungsmittel mittels Ein- und Ausgangselektroden die Gruppe von elastischen Elementen vorgeben, der das adressierbare elastische Element oder die adressierbare Untergruppe von elastischen Elementen angehören, dass auf diese Weise auch die Frequenz der Verschiebungswechselspannung vorgegeben ist, die an die Kombination der Ein- und Ausgangselektroden der vorgegebenen Gruppe von elastischen Elementen anzulegen ist und

**dass** diese Frequenz der Frequenz der Resonanzschwingungen des adressierbaren elastischen Elements oder der Untergruppe von elastischen Elementen entspricht.

17. Struktur nach Anspruch 16,
**dadurch gekennzeichnet,**
**dass** jedes elastische Element, wenn es im mechanischen Kontakt mit wenigstens einer Ausgangselektrode steht, mechanische Schwingungen mit eigener Frequenz ausführt;
**dass** diese Frequenz sich von der Eigenfrequenz dieses Elements unterscheidet, wenn kein mechanischer Kontakt vorliegt;
**dass** die Adressierungsmittel die Frequenz der Verschiebungswechselspannung vorgeben, die an die Kombination der Ein- und Ausgangselektroden der vorgegebenen Gruppe von elastischen Elementen anzulegen ist und
**dass** diese Frequenz der Resonanzschwingungsfrequenz des adressierbaren elastischen Elements im Zustand des mechanischen Kontakts entspricht oder dass diese Frequenz der Resonanzschwingungsfrequenz des adressierbaren elastischen Elements bei fehlendem mechanischen Kontakt entspricht.

18. Struktur nach den Ansprüchen 16 oder 17,
**dadurch gekennzeichnet,**
**dass** die Adressierungsmittel die Verschiebungswechselspannung vorgeben, die an die Kombination der Ein- und Ausgangselektroden der vorgegebenen Gruppe von elastischen Elementen anzulegen ist,
**dass** diese Verschiebungsspannung die Überlagerung der Wechselspannungen darstellt, deren Frequenzen unterschiedlich sind und
**dass** die Frequenz jeder dieser Spannungen der Resonanzschwingungsfrequenz eines der elastischen Elemente entspricht.

19. Struktur nach Anspruch 15,
**dadurch gekennzeichnet,**
**dass** sie zusätzlich wenigstens eines der folgenden Mittel einschließt:

- Mittel zur Kontrolle der Desorptionsgeschwindigkeit der Gasmoleküle von der Oberfläche mindestens eines elastischen Elements, wobei sie Mittel aufweisen, die den elektrischen Strom über dieses elastische Element durchlassen,oder sie enthalten einen zu diesem elastischen Element zugeordneten externen Erhitzer oder eine elektromagnetische Strahlungsquelle;
- Mittel zur Bestimmung der Verhältnisse zwischen den Verschiebungswerten der Resonanzschwingungsfrequenz von mindestens einem elastischen Element, wobei diese Verschiebung mit der Größenänderung des über dieses elastische Element fließenden elektrischen Stroms oder der Erhitzungs- oder Strahlungsintensität dieses elastischen Elements durch die externe Quelle zusammenhängt;
- Mittel zur Messung von dynamischen oder statischen Stromspannungskennlinien des Stromkreises, wobei der Stromkreis mindestens eine Eingangselektrode (3), eine Ausgangselektrode (5) und ein elastisches Element einschließt oder Mittel zur Erkennung der Änderung dieser Stromspannungskennlinien oder der Änderung der Hysterese dieser Stromspannungskennlinien;
- Mittel zur Erkennung der Adhäsionskraft zwischen mindestens einem elastischen Element und mindestens einer Ausgangselektrode, wobei diese Mittel die Größe des elektrischen Potentials erkennen, welches an dieses elastische Element und an die bestimmte Ausgangselektrode bzw. die Kombination der Ausgangselektroden anzulegen ist, um den Kontakt zwischen diesem elastischen Element und dieser Ausgangselektrode zu unterbrechen;
- Mittel zur Erkennung des Schwellenwertes bei der Elektronenemission durch mindestens ein elastisches Element oder Mittel zur Erkennung der Änderung dieser Emissionsschwelle;
- Mittel zur Erkennung der Resonanzschwingungsfrequenzverschiebung von mindestens einem elastischen Element, wobei diese Verschiebung durch die Änderung des Widerstands bedingt ist, welchen die Umgebung des elastischen Elements seiner Bewegung leistet und
- Mittel, die für die vorgegebenen Gastypen den vorrangigen Zugang zu wenigstens einem elastischen Element sicherstellen, wobei diese Mittel den Einsatz von Materialien mit selektiver Durchlassfähigkeit voraussetzen.

20. Struktur nach Anspruch 15,

**dadurch gekennzeichnet,**
**dass** wenigstens ein Teil der Oberfläche des elastischen Elements chemisch oder biologisch funktionalisiert ist.

21. Struktur nach den Ansprüchen 15 oder 19,
**dadurch gekennzeichnet,**
**dass** sie zwei oder mehr elastische Elemente umfasst, die sich nach der Länge oder nach dem effektiven Durchmesser oder nach der Struktur oder nach den Kennwerten der Oberflächenfunktionalisierung unterscheiden und dass sie auch zusätzlich Mittel zur Ermittlung der Verhältnisse zwischen den Resonanzschwingungsfrequenzverschiebungen dieser elastischen Elemente aufweist, wobei diese Verschiebung durch die physikalische oder chemische Sorption der Moleküle oder der Teilchen durch diese elastischen Elemente bedingt ist.

22. Struktur nach den Ansprüchen 15 oder 19,
**dadurch gekennzeichnet,**
**dass** sie zwei oder mehr elastische Elemente einschließt, wobei wenigstens ein Teil der elastischen Elemente baulich gegen eine Belichtung von der Umgebung geschützt ist,
**dass** die Struktur zusätzlich Mittel aufweist, die die Verschiebung der Resonanzschwingungsfrequenz der elastischen und gegen die Belichtung baulich geschützten Elemente festlegen und
**dass** diese Verschiebung durch die Temperaturänderung dieser elastischen Elemente infolge der Temperaturänderung der Umgebung oder infolge des Stromflusses durch diese Elemente bedingt ist.

23. Struktur nach Anspruch 15,
**dadurch gekennzeichnet,**
**dass** das elastische Element ein Kohlenstoffnanoröhrchen oder eine Kohlenstoffnanofaser oder ein Bündel von Kohlenstoffnanoröhrchen oder Kohlenstoffnanofasern darstellt.

24. Verfahren zur Herstellung einer Struktur für verschiedene Anwendungen in der Sensortechnik und Mikroelektronik, das Folgendes umfasst:

- die Ausbildung von wenigstens einem steuerbaren Element und wenigstens einer Ausgangselektrode, so dass entweder mindestens ein Teil der Ausgangselektrode aus einem Material ausgeführt wird, welches irreversible physikalische oder chemische Änderungen bei physikalischer oder chemischer durch das steuerbare Element vermittelter Einwirkung bewirkt oder mindestens ein Teil des steuerbaren Elements aus einem Material ausgebildet wird, welches irreversible physikalische oder chemische Änderungen bei physikalischer oder chemischer und durch die Ausgangselektrode vermittelter Einwirkung bewirkt;
- die Ausführung eines der folgenden Vorgänge:

  - entweder eine Änderung der Materialeigenschaften der Ausgangselektrode im lokalen Bereich an der Trenngrenze zwischen der Ausgangselektrode und dem steuerbaren Element, wobei in diesem Bereich diese Änderung der Eigenschaften durch die physikalische oder chemische und durch das steuerbare Element vermittelte Einwirkung ausgelöst wird oder
  - eine Änderung der Materialeigenschaften des steuerbaren Elements im lokalen Bereich an der Trenngrenze zwischen dem steuerbaren Element und der Ausgangselektrode, wobei in diesem Bereich diese Änderung der Eigenschaften durch die physikalische oder chemische und durch die Ausgangselektrode vermittelte Einwirkung hervorgerufen wird.

25. Verfahren nach Anspruch 24,
**dadurch gekennzeichnet,**
**dass** als steuerbares Element das Kohlenstoffnanoröhrchen verwendet wird, welches auf einem Träger senkrecht befestigt wird,
**dass** als Ausgangselektrode eine Schicht (4) aus einem Material auf Kohlenstoffbasis verwendet wird,
**dass** als Eigenschaftsänderungsvorgang des Materials der Ausgangselektrode ein Verfahren der lokalen anodischen Oxidation verwendet wird, wobei das steuerbare Element als Kathode und die Ausgangselektrode als Anode dient und
**dass** als Resultat eine Oxidation der Ausgangselektrode im lokalen Bereich rings um das steuerbare Element erreicht wird.

26. Verfahren nach Anspruch 24,
**dadurch gekennzeichnet,**

**dass** als steuerbares Element ein mehrschichtiges Kohlenstoffnanoröhrchen verwendet wird, welches auf einem Träger senkrecht befestigt wird,

**dass** als Ausgangselektrode eine Schicht (4) eines chemisch inerten, leitfähigen Materials und als Eigenschaftsänderungsvorgang des Materials des steuerbaren Elements eine lokale anodische Oxidation verwendet werden, wobei das steuerbare Element als Anode und die Ausgangselektrode als Kathode dient und

**dass** im Endeffekt eine Oxidation von wenigstens einer Außenschicht des mehrschichtigen Kohlenstoffnanoröhrchens erreicht wird.

27. Verfahren zur Herstellung einer Struktur für verschiedene Anwendungen in der Sensortechnik und Mikroelektronik, welches folgende Schritte einschließt:

- die Ausbildung von wenigstens einem steuerbaren Element und wenigstens einer Ausgangselektrode, wobei als steuerbares Element ein Nanoröhrchen oder eine Nanofaser oder ein Bündel von Nanoröhrchen oder Nanofasern verwendet wird und wobei mindestens ein Teil der Oberfläche des steuerbaren Elements mit einem Material beschichtet wird, welches sich seinen Eigenschaften nach sowohl vom Material des steuerbaren Elements als auch vom Material der Ausgangselektrode unterscheidet;
- eine teilweise oder vollständige Entfernung der Schicht des Materials, welches auf die Oberfläche des steuerbaren Elements aufgetragen wird und sich seinen Eigenschaften nach sowohl vom Material des steuerbaren Elements als auch vom Material der Ausgangselektrode unterscheidet.

28. Verfahren nach Anspruch 27,
**dadurch gekennzeichnet,**
**dass** als Nanoröhrchen das Kohlenstoffnanoröhrchen darstellt wird, welches auf dem Träger senkrecht befestigt wird,

**dass** die Schicht vom Material, welches mindestens auf einen Teil der Oberfläche des steuerbaren Elements aufgetragen wird und sich seinen Eigenschaften nach sowohl vom Material des steuerbaren Elements als auch von dem der Ausgangselektrode unterscheidet, als molekulare Monoschichtbelegung ausgebildet wird,

**dass** diese Monoschicht infolge des Selbstorganisationsvorgangs ausgebildet wird und

**dass** als Vorgang der teilweisen bzw. vollständigen Entfernung dieser molekularen Monoschicht selektives Ätzen verwendet wird.

5

2

3

4

1

Fig. 1

5

2

3

4

1

Fig. 2

Fig. 3

Fig. 4

Fig. 5

Fig. 6

Fig. 7

## INTERNATIONAL SEARCH REPORT

| | International application No. |
|---|---|
| | PCT/RU 2008/000331 |

| A. CLASSIFICATION OF SUBJECT MATTER |
|---|
| *B82B 1/00 (2006.01)* <br> *B82B 3/00 (2006.01)* |
| According to International Patent Classification (IPC) or to both national classification and IPC |

| B. FIELDS SEARCHED |
|---|
| Minimum documentation searched (classification system followed by classification symbols) <br><br> B82B 1/00, 3/00, G01N 27/00 |
| Documentation searched other than minimum documentation to the extent that such documents are included in the fields searched |
| Electronic data base consulted during the international search (name of data base and, where practicable, search terms used) |

| C. DOCUMENTS CONSIDERED TO BE RELEVANT | | |
|---|---|---|
| Category* | Citation of document, with indication, where appropriate, of the relevant passages | Relevant to claim No. |
| A | WO 2007/030423 A2 (NANTERO, INC) 15.03.2007, the abstract | 1-28 |
| A | US 6803840 B2 (CALIFORNIA INSTITUTE OF TECHNOLOGY) 12.10.2004, the abstract | 1-28 |
| A | RU 2238239 C1 (INSTITUT FIZIKI POLUPROVODNIKOV OBEDINENNOGO INSTITUTA FIZIKI POLUPROVODNIKOV SO RAN) 20.10.2004 | 1-28 |

| ☐ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 30 October 2008 (30.10.2008) | 20 November 2008 (20.11.2008) |
| Name and mailing address of the ISA/ | Authorized officer |
| Facsimile No. | Telephone No. |

Form PCT/ISA/210 (second sheet) (July 1998)

## INTERNATIONAL SEARCH REPORT

| International application No. |
| --- |
| **PCT/RU 2008/000331** |

---

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

---

**Box No. III    Observations where unity of invention is lacking (Continuation of item 3 of first sheet)**

This International Searching Authority found multiple inventions in this international application, as follows:

### SEE SUPPLEMENTAL SHEET

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.  Consequently, this international search report is restricted to the invention first mentioned in the claims;  it is covered by claims Nos.:

Remark on Protest          ☐ The additional search fees were accompanied by the applicant's protest and, where applicable, the payment of a protest fee.
☐ The additional search fees were accompanied by the applicant's protest but the applicable protest fee was not paid within the time limit specified in the invitation.
☐ No protest accompanied the payment of additional search fees.

Form PCT/ISA/210 (continuation of first sheet (2)) (April 2005)

| INTERNATIONAL SEARCH REPORT | International application No. |
| --- | --- |
| | PCT/RU 2008/000331 |

Claimed are three groups of inventions which are not so linked as to form a single inventive concept, since they do not contain the same or corresponding special technical features.

Group 1 (claims 1 and 24): a nanoelectromechanical structure and a process for the production thereof. The special technical features are the features relating to the choice of material of the output electrode or the controlled element.

Group 2 (claim 15): a nanoelectromechanical structure. The special technical features are the features relating to the excitation of mechanical oscillations of the controlled element for mechanical contact with the output electrode.

Group 3 (claim 27): a process for the production of a nanoelectromechanical structure. The special technical features are the features relating to the application of a layer of material to the surface of the controlled element and the subsequent partial removal of said layer.

Form PCT/ISA/210 (extra sheet) (April 2005)

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 02080360 A
- US 5719324 A
- WO 0103208 A
- US 2002167375 A
- EP 1646145 A
- CA 2581248
- US 2007063740 A
- WO 2007030423 A

**In der Beschreibung aufgeführte Nicht-Patentliteratur**

- **Ongi Englander ; Dane Christensen ; Liwei Lin.** *Applied physics letters,* 2003, vol. 82 (26), 4797-4799
- **Zhong Lin Wang ; Zhengwei Pan.** *International Journal of Nanoscience,* 2002, vol. 1 (1), 41-51
- **A.A. Stroganov.** Thesen zu den Berichten an der Konferenz. *Mikroelektronik und Informatik,* 2005
- **Yu.A. Chaplygin ; V.K. Nevolin ; S.V. Khartov.** *Berichte der Akademie für Wissenschaften,* 2007, vol. 412 (6), 1-4
- **A.A. Stroganov.** Thesen zu den Berichten an der Konferenz. *Mikroelektronik und Informatik,* 2005, 16
- **Zhou C. ; Deshpande M. R. ; Reedb M. A.** *Applied physics letters,* 1997, vol. 71 (5), 611-613
- **Tsu-Wei Chou ; Zhifeng Ren ; Rod Ruoff ; Hai Wang.** *NSF Nanoscale Science and Engineering Grantees Conference,* 2003
- **Zribi A. ; Knobloch A. ; Rao R.** *Applied Physics Letters,* 2005, vol. 86 (20
- **Bonard J.M. ; Kind H. ; Stockli T. et al.** Solid-state electronics. *Journal SSE,* 2001, 1-22
- **Li J. ; Papadopoulos C. ; Xu J.M. et al.** *Applied physics letters,* 1999, vol. 75 (3), 367-369